(19) Europäisches Patentamt / European Patent Office / Office européen des brevets

(11) **EP 3 950 572 A1**

(12) **EUROPEAN PATENT APPLICATION**
published in accordance with Art. 153(4) EPC

(43) Date of publication:
**09.02.2022 Bulletin 2022/06**

(21) Application number: **20777313.6**

(22) Date of filing: **19.02.2020**

(51) International Patent Classification (IPC):
**B81B 3/00** (2006.01)     **H01L 41/09** (2006.01)
**H01L 41/187** (2006.01)     **G02B 26/08** (2006.01)
**G02B 26/10** (2006.01)

(52) Cooperative Patent Classification (CPC):
**B81B 3/00; G02B 26/08; G02B 26/10; H01L 41/09; H01L 41/187**

(86) International application number:
**PCT/JP2020/006638**

(87) International publication number:
**WO 2020/195385 (01.10.2020 Gazette 2020/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.03.2019   JP 2019063659**

(71) Applicant: **FUJIFILM Corporation**
**Tokyo 106-8620 (JP)**

(72) Inventor: **NAONO, Takayuki**
**Ashigarakami-gun, Kanagawa 258-8577 (JP)**

(74) Representative: **Parker, Andrew James**
**Meissner Bolte Patentanwälte**
**Rechtsanwälte Partnerschaft mbB**
**Postfach 86 06 24**
**81633 München (DE)**

(54) **MICROMIRROR DEVICE AND METHOD FOR DRIVING MICROMIRROR DEVICE**

(57)    A micromirror device includes first and second actuators, which are piezoelectric actuators each having a piezoelectric element in which a lower electrode, a piezoelectric film, and an upper electrode are laminated on an oscillation plate. In each of the piezoelectric elements, each upper electrode is formed of a plurality of individual electrode parts, each of which is separated by a first stress inversion region and a second stress inversion region, and includes a plurality of piezoelectric parts respectively defined by the plurality of individual electrode parts. In the first stress inversion region, positive and negative of a principal stress component having a maximum absolute value are inverted in a principal stress generated in an in-plane direction of the piezoelectric film in a maximum displacement state in a case of driving in a first resonance mode in which the mirror part is tilted and displaced around the first axis. In the second stress inversion region, positive and negative of a principal stress component having a maximum absolute value are inverted in a principal stress generated in the in-plane direction of the piezoelectric film in a case of driving in a second resonance mode in which the mirror part is tilted and displaced around the second axis.

FIG. 1

**Description**

**BACKGROUND OF THE INVENTION**

1. Field of the Invention

The present disclosure relates to a micromirror device and a method of driving the micromirror device.

2. Description of the Related Art

A micromirror device (also referred to as a micro-scanner) is known as one of the micro electro mechanical systems (MEMS) devices manufactured by using the microfabrication technology of silicon (Si). Since this micromirror device is small and has low consumed power, it is expected that the micromirror device is applied to head-up displays, retinal displays, and the like using lasers.

As an optical scanning method for displaying images, attention has been focused on a Lissajous scanning method of covering the screen by driving sinusoidally on both the horizontal and vertical axes and drawing a Lissajous waveform, as compared with the raster scanning method that has been common until now. In the Lissajous scanning method, the algorithm of the laser driver is complicated. However, the mirror can be miniaturized, and a wide angle of view can be realized while suppressing the driving consumed power.

There are various driving methods for micromirrors, but the piezoelectric driving method using deformation of a piezoelectric body is promising since the method generates a higher torque than other methods and is capable of obtaining a high scan angle.

JP6092713B and WO2016/052547A each disclose a piezoelectric mirror device in which a mirror part is connected to a pair of semi-annular piezoelectric actuators through a torsion bar and the mirror part is able to rotate and oscillate around the torsion bar as an axis. JP6092713B and WO2016/052547A each disclose a method of efficiently driving a mirror by dividing and placing piezoelectric films in accordance with stress distribution generated in the semi-annular piezoelectric actuator in a case of oscillating the mirror part and by giving each driving signal having an appropriate polarity to each of the piezoelectric films divided and placed.

However, since the mirror device disclosed in JP6092713B and WO2016/052547A is able to scan only in one axis direction, an image cannot be displayed with one chip. To realize a two-axis scan (two-dimensional scan) using the mirror device disclosed in JP6092713B and WO2016/052547A, it is necessary to combine the mirror device with another device for realizing displacement in the other one-axis direction. As a result, there is a problem that the system is large.

On the other hand, JP5151065B, JP4984117B, and JP2018-041085A propose a piezoelectric drive type optical scanner capable of two-dimensional scanning as a micromirror device.

JP5151065B discloses an optical scanner having a configuration in which the mirror part is connected to the movable frame through the first connecting part along the first axis and the movable frame is connected to the fixed frame surrounding the movable frame through the piezoelectric actuator. The movable frame and the piezoelectric actuator are connected by a second connecting part along the second axis orthogonal to the first axis, and the piezoelectric actuator is further connected to the fixed frame by a third connecting part along the first axis. A pair of movable parts are connected to each of the two third connecting parts disposed on the axis across the mirror part, and a total of four movable parts oscillate the mirror part around two axes together with the movable frame. Thereby, a two-dimensional light scanning operation is realized.

JP4984117B discloses an optical scanner comprising: a mirror part; a first actuator part that is disposed so as to surround the mirror part and connected to the mirror part through a first torsion bar extending along a first axis; an internal movable frame that is disposed exterior to the first actuator part and is connected to the first actuator on the axis of the first torsion bar; and a second actuator part that is disposed so as to surround the internal movable frame and is connected to the internal movable frame through the second torsion bar. The first actuator applies torque around the first axis to the mirror part, and the second actuator applies torque around the second axis to the mirror part, thereby realizing a two-dimensional light scanning operation.

In JP2018-41085A, the mirror part is connected to the first frame device (the movable frame) that surrounds the mirror part through the first torsion bar, and the first frame device is connected to an actuator structure that surrounds the first frame device through the second torsion bar. Further, a configuration, in which the actuator structure is connected to a second frame device that surrounds the actuator through a third torsion bar, is disclosed. The actuator structure comprises four movable parts symmetrical to the first axis and the second axis, and the mirror part is rotated around the two axes by the four movable parts. Thereby, a two-dimensional light scanning operation is realized.

**SUMMARY OF THE INVENTION**

According to JP5151065B, JP4984117B, and JP2018-041085A, two-dimensional scanning is possible with one chip. The optical scanners of JP5151065B, JP4984117B, and JP2018-041085A each comprise a movable frame connected to a mirror part. By comprising this movable frame, the effect of oscillation insulation can be obtained such that the oscillation energy inside the movable frame does not leak to the outside or the oscillation energy from the outside does not leak to the inside. That is, by comprising the movable frame, there is an advantage that a crosstalk between the two axes at the time of scanning can be reduced. However, since the movable frame itself is unable to generate a driving force, there is a problem that energy efficiency is poor. As a result, the advantage of low consumed power in a case of using the piezoelectric actuator is not sufficiently effective.

In order to realize a practical system for displaying high-definition images, it is necessary to achieve both a high drive frequency and a wide scan angle for both scan axes while being able to perform two-dimensional scanning with one chip. For that purpose, an actuator structure that transmits power to the mirror more efficiently is essential. As described above, the configurations of JP5151065B, JP4984117B, and JP2018-041085A were not sufficient for efficiency improvement.

The present disclosure has been made in view of the above circumstances, and an object of the present disclosure is to provide a micromirror device capable of two-dimensional scanning and a method of driving the micromirror device having high drive efficiency.

Specific means for solving the above problems include the following aspects.

<1> A micromirror device comprising:

a mirror part that has a reflecting surface reflecting incident light;
a first actuator that is provided exterior to the mirror part;
a second actuator that is provided exterior to the first actuator;
a first connecting part that connects the mirror part and the first actuator and rotatably supports the mirror part on a first axis;
a second connecting part that connects the first actuator and the second actuator and rotatably supports the first actuator on a second axis intersecting the first axis; and
a third connecting part that rotatably connects the second actuator to a fixing unit provided on an outer circumference of the second actuator,
in which the first actuator and the second actuator apply rotational torque around the first axis to the mirror part and apply rotational torque around the second axis to the mirror part and the first actuator, so as to two-dimensionally rotationally drive the mirror part around the first axis and the second axis,
wherein each of the first actuator and the second actuator is a piezoelectric actuator including a piezoelectric element in which a lower electrode, a piezoelectric film, and an upper electrode are laminated on an oscillation plate, and
wherein in each of the piezoelectric elements, each upper electrode is formed of a plurality of individual electrode parts, each of which is separated by a first stress inversion region and a second stress inversion region, and includes a plurality of piezoelectric parts respectively defined by the plurality of individual electrode parts, wherein, in the first stress inversion region, positive and negative of a principal stress component having a maximum absolute value are inverted in a principal stress generated in an in-plane direction of the piezoelectric film in a maximum displacement state in a case of driving in a first resonance mode in which the mirror part is tilted and displaced around the first axis, and in the second stress inversion region, positive and negative of a principal stress component having a maximum absolute value are inverted in a principal stress generated in the in-plane direction of the piezoelectric film in a case of driving in a second resonance mode in which the mirror part is tilted and displaced around the second axis.

<2> The micromirror device according to <1>, in which the third connecting part is connected to the outer circumference of the second actuator on the second axis.

<3> The micromirror device according to <1> or <2>,

in which the first actuator includes a pair of first movable parts having semi-annular shapes,
the second actuator includes a pair of second movable parts having semi-annular shapes,
the first connecting part connects the mirror part and one end of each of the pair of first movable parts, and the mirror part and another end of each of the pair of first movable parts, on the first axis,
the second connecting part connects one of the pair of first movable parts and one end of each of the pair of second movable parts, and connects another of the pair of first movable parts and another end of each of the pair of second movable parts, on the second axis.

<4> The micromirror device according to <1> or <2>,

in which the first actuator includes a pair of first movable parts having semi-annular shapes,
the first connecting part connects the mirror part and one end of each of the pair of first movable parts, and the mirror part and another end of each of the pair of first movable parts, on the first axis,
the second actuator includes a pair of plate-shaped second movable parts and a pair of plate-shaped third movable parts, and
the second connecting part connects one of the pair of first movable parts and one end of each of the pair of second movable parts, and connects another of the pair of first movable parts and one end of each of the third movable part, on the second axis.

<5> The micromirror device according to any one of <1> to <4>, further comprising a drive circuit that inputs driving signals to the piezoelectric elements of the first actuator and the second actuator.
<6> The micromirror device according to <5>, in which the drive circuit inputs, to the respective piezoelectric elements of the first actuator and the second actuator, driving signals for driving the micromirror device in a first resonance mode in which the mirror part tilts and oscillates around the first axis and for driving the micromirror device and the first actuator in a second resonance mode in which the mirror part and the first actuator tilt and oscillate around the second axis.
<7> The micromirror device according to <6>, in which the drive circuit inputs, to each of the plurality of piezoelectric parts of each piezoelectric element, a driving signal obtained by superimposing a first driving signal and a second driving signal, wherein, in the first driving signal, a driving voltage waveform applied to a piezoelectric part located in a region where the principal stress component having the maximum absolute value is positive and a driving voltage waveform applied to a piezoelectric part located in a region where the principal stress component having the maximum absolute value is negative are in an opposite phase relationship with each other at a time when an oscillation amplitude in a case of driving in the first resonance mode is maximized, and in the second driving signal, a driving voltage waveform applied to the piezoelectric part located in a region where the principal stress component having the maximum absolute value is positive and a driving voltage waveform applied to the piezoelectric part located in a region where the principal stress component having the maximum absolute value is negative are in an opposite phase relationship with each other at a time when an oscillation amplitude in a case of driving in the second resonance mode is maximized.
<8> The micromirror device according to <6> or <7>, in which as the driving signal, the drive circuit applies a driving signal Vxy represented by Expression (1) to each of the plurality of piezoelectric parts in accordance with each placement thereof: Vxy =

$$\alpha_1 V_1 \sin(2\pi f_1 t + \beta_1 \pi) + \alpha_2 V_2 \sin(2\pi f_2 t + \beta_2 \pi) \quad (1)$$

wherein xy is a reference sign that specifies each of the plurality of piezoelectric parts, and $V_1$, $V_2$, $\alpha_1$, $\alpha_2$, $\beta_1$, $\beta_2$, $f_1$, $f_2$, and t are values which are set for each piezoelectric part,

$V_1$ is a basic voltage amplitude value of the first driving signal,
$V_2$ is a basic voltage amplitude value of the second driving signal,
$\alpha_1$ is a voltage amplitude correction coefficient for the first driving signal,
$\alpha_2$ is a voltage amplitude correction coefficient for the second driving signal,
$\beta_1$ is a phase correction coefficient for the first driving signal,
$\beta_2$ is a phase correction coefficient for the second driving signal,
fi is a frequency of the first driving signal,
$f_2$ is a frequency of the second driving signal, and
t is a time.

<9> The micromirror device according to <8>, in which the drive circuit applies the driving signal Vxy in which a value of the correction coefficient $\alpha_1$ is larger, as the piezoelectric part is located in the region where the absolute value of the principal stress component having the maximum absolute value in a case of driving in the first resonance mode is larger, and a value of the correction coefficient $\alpha_2$ is larger, as the piezoelectric part is located in the region where the absolute value of the principal stress component having the maximum absolute value in a case of driving in the second resonance mode is larger.

<10> The micromirror device according to claim any one of <6> to <9>, in which the first resonance mode is a lowest order mode of resonance modes in which the mirror part and the first actuator tilt and oscillate in opposite phases to each other.

<11> The micromirror device according to any one of <6> to <10>, in which the second resonance mode is a lowest order mode of resonance modes in which the mirror part, the first actuator, and the second actuator tilt and oscillate in opposite phases to each other.

<12> A method of driving the micromirror device according to any one of <1> to <6>, the method comprising: exciting the first resonance mode, in which the mirror part tilts and oscillates around the first axis, and the second resonance mode, in which the mirror part and the first actuator tilt and oscillate around the second axis, by applying a driving signal to the piezoelectric element of each of the first actuator and the second actuator.

<13> The method of driving the micromirror device according to <12>, in which the driving signal is applied to each of the plurality of piezoelectric parts of each piezoelectric element, the driving signal being obtained by superimposing a first driving signal and a second driving signal, wherein, in the first driving signal, a driving voltage waveform applied to a piezoelectric part located in a region where the principal stress component having the maximum absolute value is positive and a driving voltage waveform applied to a piezoelectric part located in a region where the principal stress component having the maximum absolute value is negative are in an opposite phase relationship with each other at a time when an oscillation amplitude in a case of driving in the first resonance mode is maximized, and in the second driving signal, a driving voltage waveform applied to the piezoelectric part located in a region where the principal stress component having the maximum absolute value is positive and a driving voltage waveform applied to the piezoelectric part located in a region where the principal stress component having the maximum absolute value is negative are in an opposite phase relationship with each other at a time when an oscillation amplitude in a case of driving in the second resonance mode is maximized.

<14> The method of driving the micromirror device according to <12> or <13>, in which as the driving signal, a driving signal Vxy represented by Expression (1) is applied to each of the plurality of piezoelectric parts in accordance with each placement thereof:

$$\mathrm{Vxy} = \alpha_1 V_1 \sin(2\pi f_1 t + \beta_1 \pi) + \alpha_2 V_2 \sin(2\pi f_2 t + \beta_2 \pi) \quad (1)$$

wherein xy is a reference sign that specifies each of the plurality of piezoelectric parts, and $V_1$, $V_2$, $\alpha_1$, $\alpha_2$, $\beta_1$, $\beta_2$, $f_1$, $f_2$, and t are values which are set for each piezoelectric part,

$V_1$ is a basic voltage amplitude value of the first driving signal,
$V_2$ is a basic voltage amplitude value of the second driving signal,
$\alpha_1$ is a voltage amplitude correction coefficient for the first driving signal,
$\alpha_2$ is a voltage amplitude correction coefficient for the second driving signal,
$\beta_1$ is a phase correction coefficient for the first driving signal,
$\beta_2$ is a phase correction coefficient for the second driving signal,
fi is a frequency of the first driving signal,
$f_2$ is a frequency of the second driving signal, and
t is a time.

<15> The method of driving the micromirror device according to <14>, in which in the driving signal Vxy, a value of the correction coefficient $\alpha_1$ is larger as the piezoelectric part is located in the region where the absolute value of the principal stress component having the maximum absolute value in a case of driving in the first resonance mode is larger, and a value of the correction coefficient $\alpha_2$ is larger as the piezoelectric part is located in the region where the absolute value of the principal stress component having the maximum absolute value in a case of driving in the second resonance mode is larger.

<16> The method of driving the micromirror device according to any one of <12> to <15>, in which, as the first resonance mode, a lowest order mode of the resonance modes, in which the mirror part and the first actuator tilt and oscillate in opposite phases to each other, is excited.

<17> The method of driving the micromirror device according to any one of <12> to <16>, in which, as the second resonance mode, a lowest order mode of the resonance modes, in which the first actuator, the mirror part, and the second actuator tilt and oscillate in opposite phases to each other, is excited.

According to the present disclosure, it is possible to provide a micromirror device that is capable of two-dimensional scanning and a method of driving the micromirror device having high drive efficiency.

## BRIEF DESCRIPTION OF THE DRAWINGS

Fig. 1 is a perspective view of the micromirror device of a first embodiment.

Fig. 2 is a plan view of the micromirror device of the first embodiment as viewed from the reflecting surface side of the mirror part, and is a diagram showing a region where a piezoelectric film is formed.

Fig. 3 is a plan view of the micromirror device of the first embodiment as viewed from the reflecting surface side of the mirror part, and is a diagram showing the placement of individual electrode parts of the upper electrodes.

Fig. 4 is a cross-sectional view taken along the line AB of Fig. 3.

Fig. 5 is a diagram schematically showing shape displacement in the first resonance mode accompanied by tilt oscillation of the mirror part around the first axis in the micromirror device of the first embodiment.

Fig. 6 is a diagram showing in-plane stress distribution generated in the first actuator and the second actuator due to the shape displacement in the first resonance mode shown in Fig. 5.

Fig. 7 is a diagram schematically showing shape displacement in the second resonance mode accompanied by tilt oscillation of the mirror part around the second axis in the micromirror device of the first embodiment.

Fig. 8 is a diagram showing in-plane stress distribution generated in the first actuator and the second actuator due to the shape displacement in the second resonance mode shown in Fig. 7.

Fig. 9 is a diagram for explaining voltage application in a case of driving around the first axis.

Fig. 10 is a diagram showing an applied driving signal (voltage waveform) in a case of driving around the first axis.

Fig. 11 is a diagram for explaining voltage application in a case of driving around the second axis.

Fig. 12 is a diagram showing an applied driving signal (voltage waveform) in a case of driving around the second axis.

Fig. 13 is a plan view of the micromirror device of the second embodiment as viewed from the reflecting surface side of the mirror part, and is a diagram showing a region where a piezoelectric film is formed.

Fig. 14 is a plan view of the micromirror device of the second embodiment as viewed from the reflecting surface side of the mirror part, and is a diagram showing the placement of individual electrode parts of the upper electrodes.

Fig. 15 is a diagram schematically showing shape displacement in the first resonance mode accompanied by tilt oscillation of the mirror part around the first axis in the micromirror device of the second embodiment.

Fig. 16 is a diagram showing in-plane stress distribution generated in the first actuator and the second actuator due to the shape displacement in the first resonance mode shown in Fig. 15.

Fig. 17 is a diagram schematically showing shape displacement in the second resonance mode accompanied by tilt oscillation of the mirror part around the second axis in the micromirror device of the second embodiment.

Fig. 18 is a diagram showing in-plane stress distribution generated in the first actuator and the second actuator due to the shape displacement in the second resonance mode shown in Fig. 17.

Fig. 19 is a diagram for explaining a driving method in a case of driving around the first axis.

Fig. 20 is a diagram for explaining a driving method in a case of driving around the second axis.

Fig. 21 is a diagram showing an example of design modification of a micromirror device.

Fig. 22 is a diagram defining the dimensions of each part of the micromirror device of Example 1.

Fig. 23 is a diagram showing an placement of individual electrode parts in the upper electrode of the micromirror device of Reference Example 1.

Fig. 24 is a diagram for explaining a driving method in a case of driving around the first axis of the micromirror device of Reference Example 1.

Fig. 25 is a diagram for explaining a driving method in a case of driving around the second axis of the micromirror device of Reference Example 1.

Fig. 26 is a diagram showing an placement of individual electrode parts in the upper electrode of the micromirror device of Reference Example 2.

Fig. 27 is a diagram for explaining a driving method in a case of driving around the first axis of the micromirror device of Reference Example 2.

Fig. 28 is a diagram for explaining a driving method in a case of driving around the second axis of the micromirror device of Reference Example 2.

## DESCRIPTION OF THE PREFERRED EMBODIMENTS

Hereinafter, specific embodiments of the present disclosure will be described with reference to the drawings.

[First Embodiment]

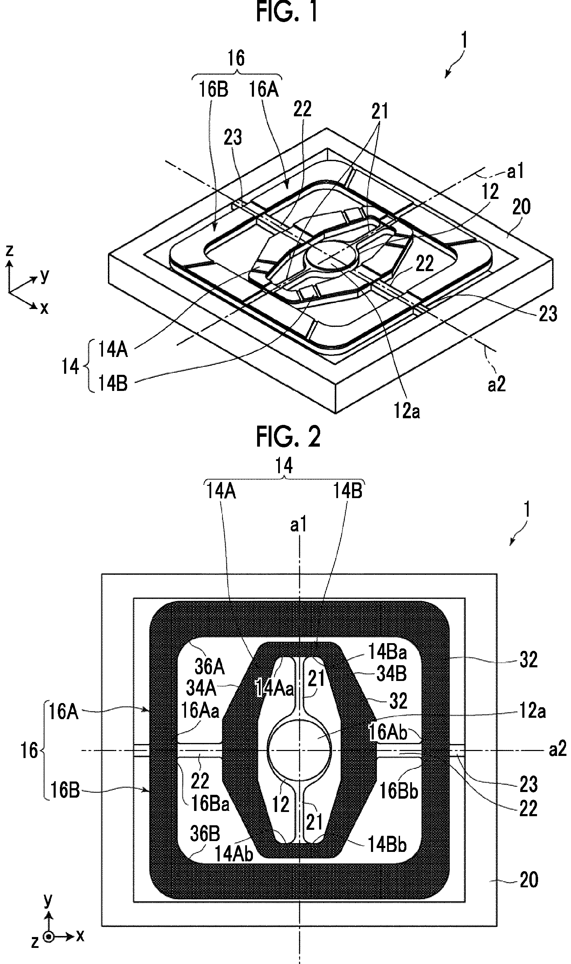

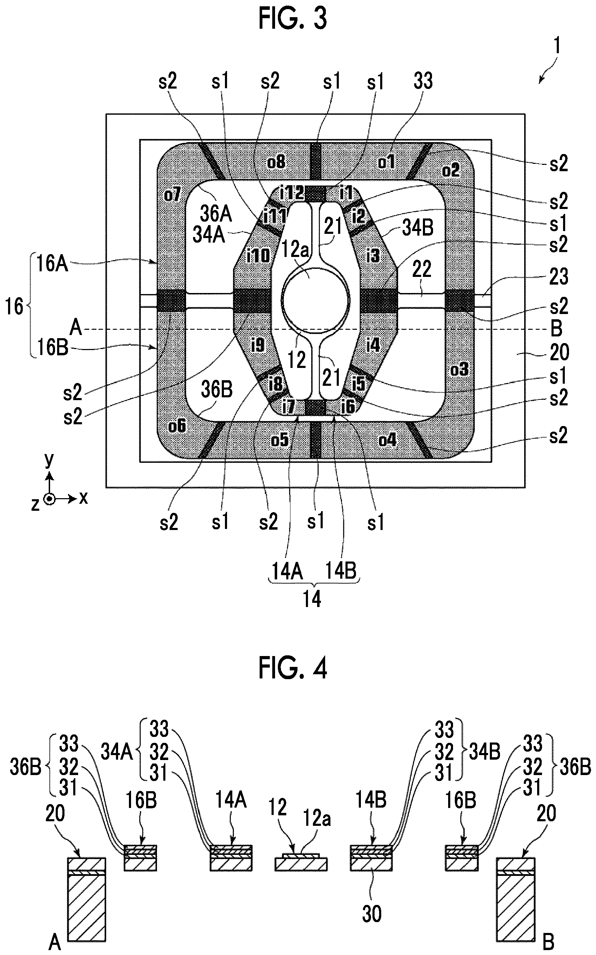

Fig. 1 is a perspective view of the micromirror device according to a first embodiment. Figs. 2 and 3 are plan views as viewed from the reflecting surface side of the mirror part. Fig. 2 is a view showing a piezoelectric film formation region, and Fig. 3 is a view showing an upper electrode formation region. Further, Fig. 4 is a cross-sectional view taken along the line AB of Fig. 3. As shown in Figs. 1 to 3, the micromirror device 1 of the present embodiment includes a mirror part 12, a first actuator 14 provided exterior to the mirror part 12, a second actuator 16 provided exterior to the first actuator 14, a fixing unit 20, a first connecting part 21, a second connecting part 22, and a third connecting part 23. The size of the micromirror device is generally, for example, about 1 mm to 10 mm in length and width, but may be smaller or larger than the above size, and is not particularly limited. Further, the thickness of the movable part is generally about 5 $\mu$m to 0.2 mm, but may be within a range in which the movable part can be manufactured, and is not particularly limited.

The mirror part 12 has a reflecting surface 12a that reflects incident light. The reflecting surface 12a is composed of a metal thin film such as Au (gold) and Al (aluminum) provided on one surface of the mirror part 12. The material and film thickness used for the mirror coating for forming the reflecting surface 12a are not particularly limited, and various designs can be made using a known mirror material, that is, a high reflectance material.

Figs. 1 and 2 exemplify a mirror part 12 having an approximately circular reflecting surface 12a and having a plan view shape similar to the reflecting surface 12a. However, the plan view shape of the mirror part 12 and the shape of the reflecting surface 12a may be the same or different. The shapes of the mirror part 12 and the reflecting surface 12a are not particularly limited. Not limited to the circular shape exemplified, there may be various shapes such as an ellipse, a square, a rectangle, and a polygon.

The first connecting part 21 connects the mirror part 12 and the first actuator 14, and rotatably supports the mirror part 12 around the first axis a1. The first connecting part 21 is a pair of rod-like members, which extend outward along the first axis a1 from the outer circumference of the mirror part 12 symmetrically with the mirror part 12 interposed therebetween. One end of each of the pair of rod-like members constituting the first connecting part 21 is connected to the outer circumference of the mirror part 12, and the other end of each is connected to the first actuator 14.

The second connecting part 22 connects the first actuator 14 and the second actuator 16 on the second axis a2 that intersects the first axis a1, and supports the first actuator 14 rotatably around the second axis a2. The second connecting part 22 is a pair of rod-like members which extend outward along the second axis a2 from the outer circumference of the first actuator 14 symmetrically with the first actuator 14 interposed therebetween. One end of each of the pair of rod-like members constituting the second connecting part 22 is connected to the outer circumference of the first actuator 14, and the other end of each is connected to the second actuator 16.

The third connecting part 23 connects the second actuator 16 and the fixing unit 20, and rotatably supports the second actuator 16. The third connecting part 23 is a pair of rod-like members extending outward along the second axis a2 from the outer circumference of the second actuator 16 symmetrically with the second actuator 16 interposed therebetween. One end of each of the pair of rod-like members constituting the third connecting part 23 is connected to the outer circumference of the second actuator, and the other end of each is connected to the fixing unit 20.

With such a configuration, the third connecting part 23 and the second connecting part 22 are provided on the same axis. Here, the first axis a1 and the second axis a2 intersect at substantially the center of the mirror part 12.

The third connecting part may be provided along the first axis a1 to connect the second actuator 16 and the fixing unit 20 on the first axis. However, it is more preferable that the second connecting part 22 and the third connecting part 23 are provided on the same second axis a2 because the non-linearity at the time of resonance can be suppressed. In such a case, since the non linearity at the time of resonance can be suppressed, the control of two-dimensional optical scanning is easy, and the angle of view (that is, a scan angle) of scanning can be sufficiently increased. As the scan angle, for example, a horizontal axis of 40° or more and a vertical axis of 30° or more are desired.

The fixing unit 20 supports the second actuator 16 through the third connecting part 23. The second actuator 16 supports the first actuator 14 through the second connecting part 22. Further, the first actuator 14 supports the mirror part 12 through the first connecting part 21. Therefore, the fixing unit 20 functions as a member for indirectly supporting the first actuator 14 and the mirror part 12 through the second actuator 16. Further, the fixing unit 20 is provided with wiring, an electronic circuit, and the like which is not shown.

In the present example, the fixing unit 20 is a frame member that surrounds the second actuator 16. The fixing unit 20 is not limited to the frame member as long as the second actuator 16 can be supported through the third connecting part 23. The fixing unit 20 may be composed of two members of a first fixing unit, which is connected to one of the third connecting parts 23, and a second fixing unit which is connected to the other thereof.

The details will be described later. However, the shape of the first actuator 14 does not matter as long as the first actuator 14 is disposed exterior to the mirror part 12 and is able to generate rotational torque around the first axis in the mirror part 12. In the present embodiment, the first actuator 14 is an annular member disposed so as to surround the mirror part 12.

Similarly, the shape of the second actuator 16 is not limited as long as the second actuator 16 is disposed on the outer circumference of the first actuator 14 and is able to generate rotational torque around the second axis in the mirror part 12 and the first actuator 14. In the present embodiment, the second actuator 16 is an annular member disposed so as to surround the first actuator 14.

Here, the exterior is used in a relative sense. Thus, the side away from the center of the mirror part as viewed from an optional position in the device is defined as the exterior. Similarly, the side facing to the center of the mirror part as viewed from an optional position is defined as the inside.

Further, the annular shape may be any shape that surrounds the inner region without interruption, and the inner and outer circumferences may not be circular, and may be any shape such as a rectangular shape or a polygonal shape. In the present example, the first and second actuators are annular. However, the shape of the actuator is not limited to annular.

The first actuator 14 and the second actuator 16 are piezoelectric actuators each including a piezoelectric element.

The first actuator 14 and the second actuator 16 apply a rotational torque to the mirror part 12 around the first axis a1 and apply a rotational torque to the mirror part 12 and the first actuator 14 around the second axis a2. Thereby, the mirror part 12 is driven to rotate two-dimensionally around the first axis a1 and the second axis a2. The driving force for applying the rotational torque around the first axis a1 to the mirror part 12 can be generated only by the first actuator 14, but may be generated by both the first actuator 14 and the second actuator 16. Further, the driving force for applying the rotational torque around the second axis a2 to the mirror part 12 and the first actuator 14 may be generated only by the second actuator 16, or may be generated by both of the first actuator 14 and the second actuator 16.

By driving the mirror part 12 in two-dimensional rotation, the micromirror device 1 reflects the incident light on the reflecting surface 12a of the mirror part 12. Thereby, it is possible to perform two-dimensional scanning.

In the following, for convenience of explanation, the normal direction of the reflecting surface 12a in a case where the mirror part 12 is stationary is the z-axis direction, the direction parallel to the first axis a1 is the y-axis direction, and the direction parallel to the second axis a2 is the x-axis direction.

The first actuator 14 is an annular thin plate member that surrounds the mirror part 12 in the x-y plane. In the present example, the first actuator 14 includes a pair of first movable parts 14A and 14B having semi-annular shapes. Further, as shown in Fig. 2, the first connecting part 21 connects the mirror part 12 and one end 14Aa and 14Ba of each of the pair of the first movable parts 14A and 14B, and connects the mirror part 12 and the other end 14Ab and 14Bb of each of the pair of the first movable parts 14A and 14B, on the first axis a1. That is, the pair of first movable parts 14A and 14B are connected on the first axis a1 and are disposed so as to form an annular shape as a whole.

The second actuator 16 is an annular thin plate member that surrounds the first actuator 14 in the x-y plane. In the present example, the second actuator 16 includes a pair of second movable parts 16A and 16B having semi-annular shapes. Further, as shown in Fig. 2, the second connecting part 22 connects one (here, the first movable part 14A) of the pair of first movable parts 14A and 14B and one end 16Aa and 16Ba of each of the pair of second movable parts 16A and 16B, and connects the other (here, the first movable part 14B) of the pair of first movable parts 14A and 14B and the other end 16Ab and 16Bb of each of the pair of second movable parts 16A and 16B, on the second axis a2. That is, the pair of second movable parts 16A and 16B are connected on the second axis a2 and are disposed so as to form an annular shape as a whole.

In the micromirror device 1 of the present example, the mirror part 12, the first actuator 14, the second actuator 16, the fixing unit 20, and the first to third connecting parts 21 to 23 are disposed to have a line-symmetrical structure in the first axis a1 and the second axis a2. With such a symmetrical structure, rotational torque can be efficiently applied to the central mirror part 12.

The micromirror device 1 can be manufactured as a structure, in which elements such as the mirror part 12, the first actuator 14, the second actuator 16, the fixing unit 20, and the first to third connecting parts 21 to 23 are integrally formed, for example, by being processed from a silicon substrate through a semiconductor manufacturing technology.

The thicknesses of the mirror part 12, the first actuator 14, the second actuator 16, and the first to third connecting parts 21 to 23 are formed to be less than the thickness (thickness in the z direction) of the fixing unit 20. Thereby, the first actuator 14, the second actuator 16, and the first to third connecting parts 21 to 23 each have a structure which tends to cause deformation (such as bending deformation and twisting deformation).

In the first actuator 14, the pair of first movable parts 14A and 14B are provided with piezoelectric elements 34A and 34B, respectively. Further, in the second actuator 16, the pair of second movable parts 16A and 16B are provided with piezoelectric elements 36A and 36B, respectively. The first actuator 14 and the second actuator 16 causes the driving force by bending and displacing the movable parts through the deformation of the piezoelectric film due to the application of a predetermined voltage to the piezoelectric elements 34A, 34B, 36A, and 36B.

In the micromirror device 1, the first actuator 14 and the second actuator 16 perform driving in a resonance mode in which the mirror part 12 tilts and oscillates around the first axis a1, and perform driving in a resonance mode in which the mirror part 12 and the first actuator 14 tilts and oscillates around the second axis a2. The micromirror device 1 is able to perform a two-dimensional scan of light by combining the drive in the first resonance mode and the drive in the second resonance mode and tilting and oscillating the mirror part 12 around the first axis and the second axis.

The piezoelectric elements 34A, 34B, 36A, and 36B each have a laminated structure in which the lower electrode 31, the piezoelectric film 32, and the upper electrode 33 are laminated in this order on the oscillation plate 30 as a movable part substrate (refer to Fig. 4). In Fig. 2, the dark-colored hatched part shows the piezoelectric film 32. That is, Fig. 2 shows a region where the piezoelectric film 32 is formed in the first actuator 14 and the second actuator 16. Further, in Fig. 3, the dark-colored hatched part shows the piezoelectric film 32, and the light-colored hatched part shows the upper electrode 33. That is, Fig. 3 shows a region where the upper electrode 33 is formed in the first actuator 14 and the second actuator 16. Here, the "upper" and "lower" of the upper electrode and the lower electrode do not mean the top and bottom. Among the pair of electrodes sandwiching the piezoelectric film, the electrode provided on the oscillation plate side is merely referred to as the lower electrode, and the electrode disposed so as to face the lower electrode with the piezoelectric film interposed therebetween is merely referred to as the upper electrode.

In the present embodiment, the piezoelectric elements 34A, 34B, 36A, and 36B is provided over substantially the entire surface of each of the movable parts 14A, 14B, 16A, and 16B, but may be provided only in a part thereof in each movable part.

The upper electrode 33 of the piezoelectric element 34A in the first movable part 14A of the first actuator 14 consists of six individual electrode parts i7, i8, i9, i10, i11, and i12. The individual electrode parts i7 to i12 are formed separately from each other. Similarly, the upper electrode 33 of the piezoelectric element 34B in the movable part 14B of the first actuator 14 consists of six individual electrode parts i1, i2, i3, i4, i5, and i6. The individual electrode parts i1 to i6 are formed separately from each other.

The upper electrode 33 of the piezoelectric element 36A in the movable part 16A of the second actuator 16 consists of four individual electrode parts o1, o2, o7, and o8. The individual electrode parts o1, o2, o7, and o8 are formed separately from each other. Similarly, the upper electrode 33 of the piezoelectric element 36B in the movable part 16B of the second actuator 16 consists of four individual electrode parts o3, o4, o5, and o6. The upper individual electrode parts o3 to o6 are formed separately from each other.

The individual electrode parts i1 to i12 and o1 to o8 each are separated by a first stress inversion region s1 and a second stress inversion region s2. In the first stress inversion region s1, positive and negative of a principal stress component having a maximum absolute value are inverted in a principal stress generated in an in-plane direction of the piezoelectric film in a case of driving in a first resonance mode in which the mirror part 12 tilts and oscillates around the first axis a1. In the second stress inversion region, positive and negative of a principal stress component having a maximum absolute value are inverted in a principal stress generated in the in-plane direction of the piezoelectric film in a case of driving in a second resonance mode in which the mirror part is tilted and displaced around the second axis. By forming the upper electrode separately into a plurality of individual electrode parts, it is possible to independently control the voltage for each piezoelectric part defined by each individual electrode part. The piezoelectric part is composed of an individual electrode part, an opposing lower electrode, and a piezoelectric film interposed between the individual electrode part and the lower electrode. The individual electrode parts i1 to i12, o1 to o8, and the lower electrode 31 are connected to the drive circuit through electrode pads and wirings which are not shown, respectively. Each principal stress and stress inversion region will be described later.

In the present embodiment, the piezoelectric film 32 and the lower electrode 31 are formed as a film common to a plurality of piezoelectric parts. However, the piezoelectric film 32 or the piezoelectric film 32 and the lower electrode 31 may be separated for each individual electrode part of the upper electrode 33.

Since the micromirror device of the present disclosure has a structure that does not have a movable frame leading to an increase in mass, that is, a frame contributing to driving without the piezoelectric film, the moment of inertia in the rotation in the second axis can be reduced and the resonance frequency can be increased. For example, a driving frequency of 40 kHz or more on the horizontal axis and 10 kHz or more on the vertical axis can be realized. Therefore, high speed driving can be performed on both the first axis and the second axis. That is, the high speed driving is suitable for Lissajous scanning in which driving in a sinusoidal manner on both the horizontal axis and the vertical axis is performed. Further, both the first and second actuators are piezoelectric actuators comprising piezoelectric elements and do not require an external driving mechanism. Therefore, the volume of the element can be reduced to a small size. Since a piezoelectric element is not provided and a movable frame that does not contribute to driving is not provided, drive efficiency is high, and consumed power can be reduced.

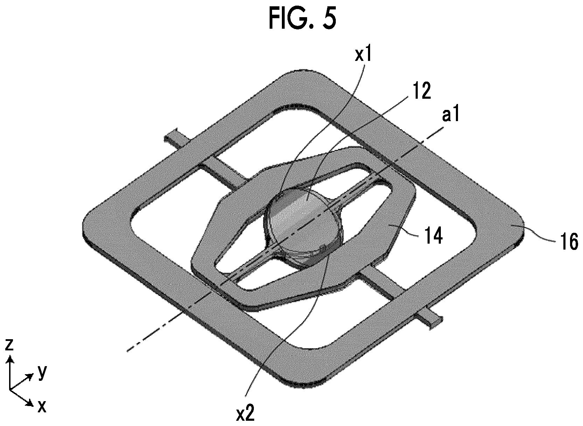

Fig. 5 is a diagram schematically showing how the mirror part 12 tilts and oscillates around the first axis a1 in the first resonance mode, and shows a state in which one end x1 of the mirror part 12 in the x-axis direction around the first axis a1 is tilted and displaced in the +z direction and the other end x2 thereof in the x-axis direction is tilted and displaced in the -z direction. In Fig. 5, the shade of color indicates the amount of displacement.

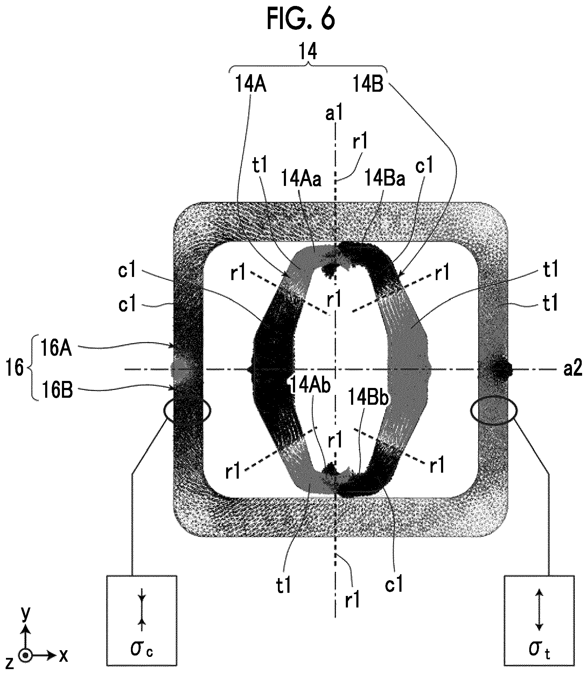

In a case where the mirror part 12 tilts and oscillates around the first axis a1 in the first resonance mode and is tilted and displaced as shown in Fig. 5, the first actuator 14 and the second actuator 16 bend and deform. Then, as shown in Fig. 6, tensile stress regions t1 and compressive stress regions c1 are generated. In each tensile stress region, a stress in the tensile direction (hereinafter referred to as a tensile stress) $\sigma t$ is applied to the piezoelectric films of the first actuator 14 and the second actuator 16. In each compressive stress region c1, a stress in the compression direction (hereinafter referred to as a compressive stress) $\sigma c$ is applied thereto. In Fig. 6, the part to which the tensile stress is applied is shown in light gray, and the part to which the compressive stress is applied is shown in black. It should be noted that the higher the color density is, the larger the stress is. The stress generated at each position of the piezoelectric film changes with time in accordance with the oscillation. Fig. 6 shows the state of in-plane stress generated in the piezoelectric film at the time when the oscillation amplitude in a case of driving in the first resonance mode is maximized.

Whether each part is "compressive stress" or "tensile stress" is determined by the direction in which the absolute value is larger (that is, the direction of the principal stress component having the maximum absolute value) of two principal stresses in a plane substantially orthogonal to the film thickness direction of the piezoelectric film which are selected from three principal stress vectors orthogonal to each other. In a case where the film thickness direction is taken on the z-axis, the two principal stresses in the plane substantially orthogonal to the film thickness direction are the stresses generated in the x-y plane. As the notation method of the stress direction, the vector in the outward direction is defined as the tensile direction, and the vector in the inward direction is defined as the compression direction.

The reason for defining in such a manner is that, in a piezoelectric MEMS device, the dimensions of the actuator part are generally planar, and the stress in the film thickness direction can be regarded as almost 0. The phrase "dimensions are planar" means that the height is sufficiently smaller than the dimensions in the plane direction. The plane direction of the above-mentioned "x-y plane" corresponds to the "in-plane direction orthogonal to the film thickness direction of the piezoelectric film". The stress is defined as follows. The tensile stress $\sigma t$ applying a force in the direction in which the member is pulled is positive, and the compressive stress $\sigma c$ applying a force in the direction in which the member is compressed is negative. That is, the region where the principal stress component having the maximum absolute value is positive means a region where the tensile stress is dominant, and the region where the principal stress component having the maximum absolute value is negative means a region where the compressive stress is dominant. Further, the term "stress inversion region in which the positive and negative of the principal stress component having the maximum absolute value is inverted" means a region including the boundary between the tensile stress region and the compressive stress region, and a region that the stress changes from the tensile stress to the compressive stress or from the compressive stress to the tensile stress.

As shown in Fig. 6, the region including one end 14Aa of one movable part 14A of the first actuator 14 and the region including the other end 14Ab thereof are the tensile stress regions t1, respectively, and the central region intersecting the second axis a2 between the two tensile stress regions t1 is the compressive stress region c1. The region including one end 14Ba and the region including the other end 14Bb of the other movable part 14B of the first actuator 14 are the compressive stress regions c1, respectively, and the central region intersecting the second axis a2 between the two compressive stress regions c1 is the tensile stress region t1. In the first resonance mode, stress distribution in the first actuator 14 is axisymmetric with respect to the second axis a2.

Further, in one movable part 16A and the other movable part 16B of the second actuator 16, the right side of the paper surface is the tensile stress region t1 and the left side of the paper surface is the compressive stress region c1, with the first axis a1 interposed therebetween. In the first resonance mode, stress distribution in the second actuator 16 is axisymmetric with respect to the second axis a2.

At the boundary between the compressive stress region c1 and the tensile stress region t1, the first stress inversion region is present, which is a region where the direction of stress gradually changes, that is, a region where the positive and negative of the principal stress component having the maximum absolute value is inverted. The stress inversion line r1 shown in Fig. 6 is located at the center of the first stress inversion region.

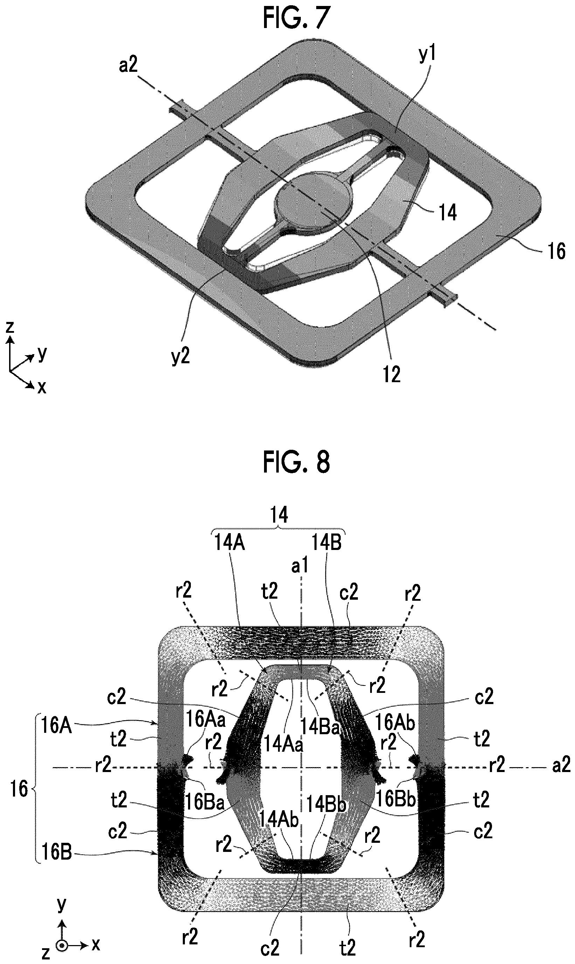

Fig. 7 is a diagram schematically showing a situation in which the mirror part 12 and the first actuator 14 tilt and oscillate around the second axis a2 in the second resonance mode, and shows a state in which one end y1 in the y-axis direction of the first actuator 14 is tilted and displaced in the +z direction and the other end y2 in the y-axis direction is tilted and displaced in the -z direction with respect to the second axis a2 as a center of the mirror part 12 and the first actuator 14. Similarly to Fig. 5, in Fig. 7, the shade of color indicates the amount of displacement.

In the second resonance mode, in a case where the mirror part 12 and the first actuator 14 are tilted and oscillated around the second axis a2 and are tilted and displaced as shown in Fig. 7, the first actuator 14 and the second actuator 16 bend and deform. Then, as shown in Fig. 8, the piezoelectric films of the first actuator 14 and the second actuator 16 have the tensile stress region t2 to which a tensile stress is applied and a compressive stress region c2 to which a compressive stress is applied. In Fig. 8, similarly to Fig. 6, the part where the tensile stress is generated is shown in light gray, and the part where the compressive stress is generated is shown in black. It should be noted that the higher the color density is, the larger the stress is. The stress generated at each position of the piezoelectric film changes with time in accordance with the oscillation. Fig. 8 shows the state of in-plane stress generated in the piezoelectric film at the time when the oscillation amplitude in a case of driving in the second resonance mode is maximized.

As shown in Fig. 8, the region including one end 14Aa and one end 14Ba of the adjacent movable part 14A and the other movable part 14B of the first actuator 14 is the tensile stress region t2, and the region including the other end 14Ab and the other end 14Bb thereof is the compressive stress region c2. Further, the parts between the ends of each of one movable part 14A and the other movable part 14B are the compressive stress region c2 on the upper side of the paper surface and the tensile stress region t2 on the lower side of the paper surface with the second axis a2 set as a boundary. In the second resonance mode, stress distribution in the first actuator 14 is axisymmetric with respect to the first axis a1.

Further, a region extending in the y direction including one end 16Aa of one movable part 16A of the second actuator 16 and a region extending in the y direction including the other end 16Ab are the tensile stress regions t2, and the central region intersecting the first axis a1 between the two tensile stress regions t2 is the compressive stress region c2. The region extending in the y direction including one end 16Ba of the other movable part 16B of the second actuator 16 and the region extending in the y direction including the other end 16Bb are the compressive stress regions c2, and the central region intersecting the first axis a1 between the two compressive stress regions c2 is the tensile stress region t2. In the second resonance mode, stress distribution in the second actuator 16 is axisymmetric with respect to the first axis a1.

At the boundary between the compressive stress region c2 and the tensile stress region t2, the second stress inversion region is present, which is a region where the direction of stress gradually changes, that is, a region where the positive and negative of the principal stress component having the maximum absolute value is inverted. The stress inversion line r2 shown in Fig. 8 is located at the center of the second stress inversion region.

The individual electrode parts of the upper electrodes are formed so as to correspond to division of the piezoelectric film regions t1, t2, c1 and c2 having different stress directions with respect to stress distribution shown in Figs. 6 and 8. Each individual electrode part is separated by a first stress inversion region s1 including the stress inversion line r1 and a second stress inversion region s2 including the stress inversion line r2 (refer to Fig. 3).

The stress distribution during operation using resonance mode oscillation (resonance drive) can be analyzed by parameters such as device dimensions, Young's modulus of material, and device shape given using the known finite element method software through the mode analysis method. In design of the device, stress distribution in the piezoelectric film in a case of driving in the resonance mode is analyzed, and the upper electrodes are divided into individual electrode parts, in accordance with the division of the compressive stress region and the tensile stress region in stress distribution, based on the analysis result. Each piezoelectric part is defined by each individual electrode part.

In the first actuator 14 and the second actuator 16, by disposing the piezoelectric parts in accordance with the parts having different generated stress directions, an appropriate driving signal can be input to each of them. Therefore, the piezoelectric force can be efficiently converted into a displacement.

The driving power for driving in the first resonance mode and the second resonance mode is supplied to each piezoelectric part from the drive circuit. As the driving signal supplied to each of the first actuator 14 and the second actuator 16, an AC signal or a pulse waveform signal having a frequency that excites resonance can be used. Specific driving signals will be described below together with the driving method.

The drive circuit inputs a driving signal, in which a first driving signal for driving the first resonance mode and a second driving signal for driving the second resonance mode are superimposed, to each of the plurality of piezoelectric parts of the piezoelectric element.

The first driving signal is a signal which includes driving voltage waveforms having opposite phases to each other. The signal is for giving the driving voltage waveform of one of the phases to the piezoelectric part located in the region, in which the principal stress component having the maximum absolute value at the time when the oscillation amplitude is maximized in a case of driving in the first resonance mode is positive, and for giving the driving voltage waveform of the other phase to the piezoelectric part located in the region in which the principal stress component having the maximum absolute value is negative at the above moment.

The second driving signal is a signal which includes driving voltage waveforms having opposite phases to each other. The signal is for giving the driving voltage waveform of one of the phases to the piezoelectric part located in the region, in which the principal stress component having the maximum absolute value at the time when the oscillation amplitude is maximized in a case of driving in the second resonance mode is positive, and for giving the driving voltage waveform of the other phase to the piezoelectric part located in the region in which the principal stress component having the maximum absolute value is negative.

Therefore, the drive circuit applies, as the first driving signals, driving signal waveforms having the same phase to the piezoelectric parts located in the regions in which the principal stress component having the maximum absolute value at the time when the drive amplitude is maximized in a case of driving in the first resonance mode has the same direction (that is, the same sign). That is, a driving signal waveform having the same phase is applied to the piezoelectric parts located in the compressive stress regions, and a driving signal waveform having the same phase is applied to the piezoelectric parts located in the tensile stress regions. Then, the drive circuit applies, as the first driving signals, driving signal waveforms having the opposite phases to the piezoelectric parts located in the regions in which the principal stress component having the maximum absolute value at the time when the drive amplitude is maximized in a case of driving in the first resonance mode has the different directions (that is, the different signs). That is, driving signal waveforms having opposite phases are applied to the compressive stress regions and the tensile stress regions. The amplitudes of the driving signal waveforms having the same phase may be the same between the piezoelectric parts, or may be different between the piezoelectric parts.

At the same time, the drive circuit applies, as the second driving signals, driving signal waveforms having the same phase to the piezoelectric parts located in the regions in which the principal stress component having the maximum absolute value at the time when the drive amplitude is maximized in a case of driving in the second resonance mode has the same direction. That is, a driving signal waveform having the same phase is applied to the piezoelectric parts located in the compressive stress regions, and a driving signal waveform having the same phase is applied to the piezoelectric parts located in the tensile stress regions. Then, the drive circuit applies, as the second driving signals, driving signal waveforms having the opposite phases to the pressure parts located in the regions in which the principal stress component having the maximum absolute value at the time when the drive amplitude is maximized in a case of driving in the second resonance mode has the different directions. That is, driving signal waveforms having opposite phases are applied to the compressive stress regions and the tensile stress regions. The amplitudes of the driving signals having the same phase may be the same between the piezoelectric parts, or may be different between the piezoelectric parts.

The first resonance mode and the second resonance mode can be excited at the same time by applying a driving signal, in which the first driving signal for the first resonance mode and the second driving signal for the second resonance mode are superimposed, to each piezoelectric part. In a case where the driving signal is given to each piezoelectric part to drive the first actuator 14 and the second actuator 16, a positive voltage is applied to the piezoelectric parts located in the regions where the principal stress component having the maximum absolute value in the principal stresses generated in the respective piezoelectric films at the time of each oscillation is positive, and a negative voltage is applied to the piezoelectric parts located in the regions where the principal stress component having the maximum absolute value is negative. By applying a positive or negative voltage in accordance with the positive or negative of the strain, the piezoelectric force can be converted into the displacement very efficiently. Therefore, it is possible to significantly reduce power consumption.

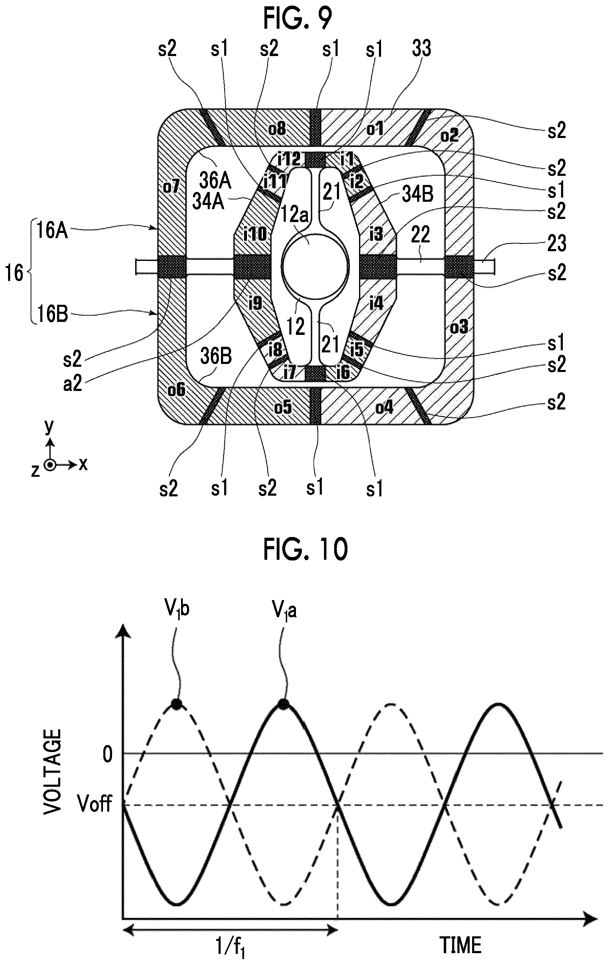

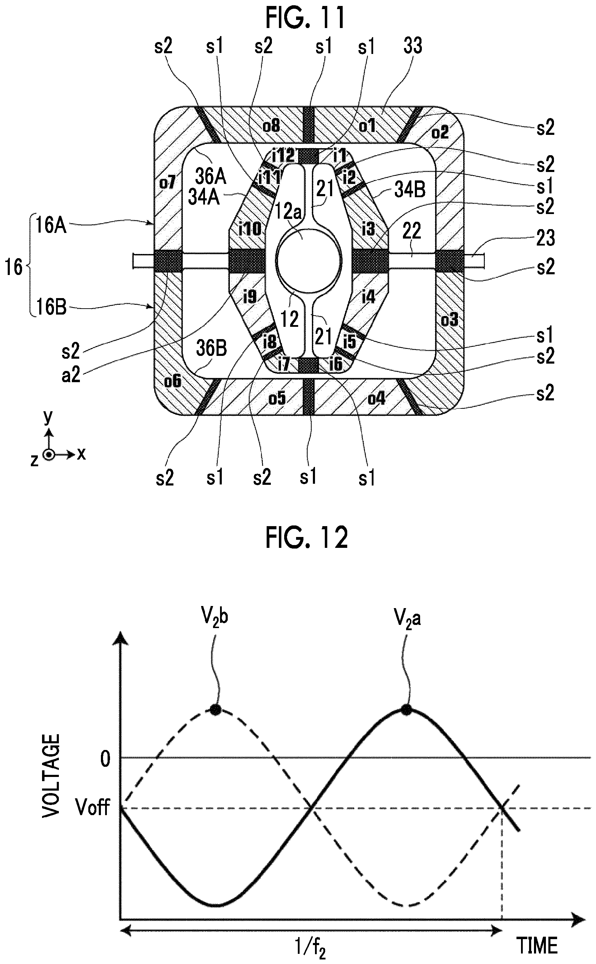

An example of the driving method will be specifically described with reference to Figs. 9 to 12. Fig. 9 is a diagram showing a piezoelectric part group to which a driving signal having the same phase is input in a case where the first resonance mode is excited. Fig. 10 shows an example of a driving signal which is input to each piezoelectric part group. Fig. 11 is a diagram showing a piezoelectric part group to which a driving signal having the same phase is input in a case where the second resonance mode is excited. Fig. 12 shows a driving signal which is input to each piezoelectric part group.

In Fig. 9, the individual electrode parts of the piezoelectric parts of the first group to which the driving signals having the same phase are input in a case where the first resonance mode is excited are indicated by diagonal right downward lines. Further, the individual electrode parts of the piezoelectric parts of the second group to which the driving signal having the opposite phase to that of the first group is input are indicated by diagonal right upward lines.

The individual electrode parts i1, i2, i5, i6, i9, i10, and o5, o6, o7, o8 of the first group correspond to the compressive stress regions c1 of Fig. 6, and the first driving signal $V_1a$ for the first resonance mode having the same phase shown in Fig. 10 is input to the individual electrode parts. The individual electrode parts i3, i4, i7, i8, i11, i12, and o1, o2, o3, o4 of the second group correspond to the tensile stress regions t1 in Fig. 6, and the first driving signal $V_1b$ for the resonance mode having the same phase is input to the individual electrode parts. As shown in Fig. 10, the driving signal $V_1a$ applied to the piezoelectric parts of the first group and the driving signal $V_1b$ applied to the piezoelectric parts of the second group have the same first frequency fi and are signals having opposite phases (phase difference 180°). By applying such a driving signal, a distortion that tilts the first actuator 14 around the first axis a1 is generated, and a rotational torque around the first axis a1 is given to the mirror part 12.

The first driving signals $V_1a$ and $V_1b$ are represented as follows, respectively.

$$V_1a = \alpha_1 V_1 \sin(2\pi f_1 t + \pi)$$

$$V_1b = \alpha_1 V_1 \sin 2\pi f_1 t$$

In the above expression, $\alpha_1 V_1$ is the voltage amplitude and t is the time. The offset voltage is not considered in the expression. $V_1$ is a basic voltage amplitude value of the first driving signal, and $\alpha_1$ is a voltage amplitude correction coefficient for the first driving signal. The voltage amplitude given to each individual electrode part may be the same or different. That is, the value of $\alpha_1$ may be different for each piezoelectric part. The voltage amplitude may be set in accordance with the magnitude of the stress generated in each individual electrode part. For example, the larger the magnitude of the stress generated in the individual electrode part, the larger the voltage amplitude.

In a case of collecting and generalizing the first driving signals $V_1a$ and Vib,
an expression can be represented as $V_1 = \alpha_1 V_1 \sin(2\pi f_1 t + \beta_1 \pi)$.

Here, $\beta_1$ is a phase correction coefficient for the first driving signal, and is 1 in the case of $V_1a$ having the first

phase and is 0 in the case of $V_1b$ having the second phase, which is the opposite phase to the first phase.

In Fig. 11, the individual electrode parts of the piezoelectric parts of the third group to which the driving signals having the same phase are input in a case where the second resonance mode is excited are indicated by diagonal right downward lines. Further, the individual electrode parts of the piezoelectric parts of the fourth group to which the driving signal having the opposite phase to that of the third group is input are indicated by diagonal right upward lines.

The individual electrode parts i2, i3, i6, i7, i10, i11, and o1, o3, o6, o8 of the third group correspond to the compressive stress regions c2 of Fig. 8, and the second driving signal $V_2a$ for the second resonance mode having the same phase shown in Fig. 12 is input to the individual electrode parts. The individual electrode parts i1, i4, i5, i8, i9, i12, and o2, o4, o5, o7 of the fourth group correspond to the tensile stress regions t2 in Fig. 8, and the second driving signal $V_2b$ for the second resonance mode having the same phase is input to the individual electrode parts. As shown in Fig. 12, the second driving signals $V_2a$ and $V_2b$ have the same second frequency $f_2$ and are signals having opposite phases (phase difference 180°). By applying such a driving signal, a distortion that tilts the first actuator 14 around the second axis a2 is generated. As a result, a rotational torque around the second axis a2 is given to the mirror part 12.

The second driving signals $V_2a$ and $V_2a$ are represented as follows, respectively.

$$V_2a = \alpha_2 V_2 \sin(2\pi f_2 t + \pi)$$

$$V_2b = \alpha_2 V_2 \sin 2\pi f_2 t$$

In the above expression, $\alpha_2 V_2$ is the voltage amplitude and t is the time. The offset voltage is not considered in the expression. $V_2$ is a basic voltage amplitude value of the second driving signal, and $\alpha_2$ is a voltage amplitude correction coefficient for the second driving signal. The voltage amplitude given to each individual electrode part may be the same or different. That is, the value of $\alpha_2$ may be different for each piezoelectric part. The voltage amplitude may be set in accordance with the magnitude of the stress generated in each individual electrode part. For example, the larger the magnitude of the stress generated in the individual electrode part, the larger the voltage amplitude.

In a case of collecting and generalizing the second driving signals $V_2a$ and $V_2b$, an expression can be represented as $V_2 = \sigma_2 V_2 \sin(2\pi f_2 t + \beta_2 \pi)$.

Here, $\beta_2$ is the phase correction coefficient of the second driving signal, and is 1 in the case of $V_2a$ having the first phase and is 0 in the case of $V_2b$ having the second phase, which is the opposite phase to the first phase.

The driving signal, in which the first driving signal for the first resonance mode and the second driving signal for the second resonance mode are superimposed, is applied to each piezoelectric part. For example, $V_1a+V_2b$ is applied to the individual electrode part i1, $V_1a+V_2a$ is applied to the individual electrode part i2, $V_1b+V_2a$ is applied to the individual electrode part i3, and $V_1b+V_2b$ is applied to the individual electrode part i4. Table 1 shows the combinations applied to each piezoelectric part.

[Table 1]

| Individual electrode part | 1-dimensional scanning | 1-dimensional scanning | 2-dimensional scanning |
|---|---|---|---|
| | (around first axis) | (around second axis) | (around first and second axes) |
| xy | first driving signal | second driving signal | driving signal |
| i1 | $V_1a$ | $V_2b$ | $V_1a+V_2b$ |
| i2 | $V_1a$ | $V_2a$ | $V_1a+V_2a$ |
| i3 | $V_1b$ | $V_2a$ | $V_1b+V_2a$ |
| i4 | $V_1b$ | $V_2b$ | $V_1b+V_2b$ |
| i5 | $V_1a$ | $V_2b$ | $V_1a+V_2b$ |
| i6 | $V_1a$ | $V_2a$ | $V_1a+V_2a$ |
| i7 | $V_1b$ | $V_2a$ | $V_1b+V_2a$ |
| i8 | $V_1b$ | $V_2b$ | $V_1b+V_2b$ |
| i9 | $V_1a$ | $V_2b$ | $V_1a+V_2b$ |
| i10 | $V_1a$ | $V_2a$ | $V_1a+V_2a$ |

(continued)

| Individual electrode part | 1-dimensional scanning | 1-dimensional scanning | 2-dimensional scanning |
|---|---|---|---|
| | (around first axis) | (around second axis) | (around first and second axes) |
| xy | first driving signal | second driving signal | driving signal |
| ill | $V_1b$ | $V_2a$ | $V_1b+V_2a$ |
| i12 | $V_1b$ | $V_2b$ | $V_1b+V_2b$ |
| o1 | $V_1b$ | $V_2a$ | $V_1b+V_2a$ |
| o2 | $V_1b$ | $V_2b$ | $V_1b+V_2b$ |
| o3 | $V_1b$ | $V_2a$ | $V_1b+V_2a$ |
| o4 | $V_1b$ | $V_2b$ | $V_1b+V_2b$ |
| o5 | $V_1a$ | $V_2b$ | $V_1a+V_2b$ |
| o6 | $V_1a$ | $V_2a$ | $V_1a+V_2a$ |
| o7 | $V_1a$ | $V_2b$ | $V_1a+V_2b$ |
| o8 | $V_1a$ | $V_2a$ | $V_1a+V_2a$ |

The driving signal applied to each piezoelectric part xy can be represented by General Expression (1).

$$Vxy = \alpha_1 V_1 \sin(2\pi f_1 t + \beta_1 \pi) + \alpha_2 V_2 \sin(2\pi f_2 t + \beta_2 \pi) \quad (1)$$

Here, xy is a reference sign for specifying which part of which actuator is the individual electrode part. In the case of the placement of the individual electrode parts shown in Fig. 3, x = i and o. In a case where x = i, y = 1 to 12. In a case where x = o, y = 1 to 8.

In Expression (1), the first term is the first driving signal for tilting and oscillating around the first axis, and the second term is the second driving signal for tilting and oscillating around the second axis.

In the example shown in Table 1 above, $\alpha_1$ and $\alpha_2$ are constant. However, $\alpha_1$ and $\alpha_2$ are made different for each individual electrode, and as the magnitude of stress generated in the individual electrode part is larger, the voltage amplitude is made to be larger. Thereby, it is possible to further increase the drive efficiency and further reduce the power consumption.

As described above, driving thereof can be very efficiently performed by controlling so as to apply the driving signal to each piezoelectric part according to the direction of the principal stress component having the maximum absolute value in the principal stresses generated in the piezoelectric films of the first actuator and the second actuator in a case of driving the micromirror device in the first resonance mode and the second resonance mode. The drive circuit is configured to input the driving signal to each piezoelectric part.

In the present embodiment, the lower electrodes of the plurality of piezoelectric parts included in each piezoelectric element are common electrodes. Therefore, the lower electrode is grounded and a predetermined driving signal (driving voltage waveform) is input to the upper electrode. However, in a case where the lower electrode is also an individual electrode, either the lower electrode or the upper electrode may be used as the earth electrode as long as a driving signal can be applied between the lower electrode and the upper electrode.

As the resonance mode, there is not only a mode accompanied by rotation (tilt oscillation) of the mirror part 12 around the axis, but also a mode accompanied by a piston motion in the vertical direction, a twisting motion in a plane, or the like. However, in the micromirror device 1 of the present embodiment, the mirror part 12 is driven by using a resonance mode accompanied by tilt oscillation.

In addition, as the first resonance mode in which the mirror part 12 tilts and oscillates around the first axis, in the resonance mode in which the mirror part 12 and the first actuator 14 oscillate in opposite phases, the Q value of the resonance oscillation is higher and the resonance frequency is higher than that in the resonance mode in which the mirror part 12 and the first actuator 14 oscillate in the same phase. As a result, it is more suitable that scanning is performed at high speed. For example, in the micromirror device of Example 1 described later, the resonance frequency of the in-phase resonance mode around the first axis was 35 kHz, and the Q value was 700. On the other hand, the resonance frequency of the resonance mode having the opposite phase around the first axis was 60 kHz, and the Q value was 1900. It is preferable to perform driving in the lowest order mode among the resonance modes in which the mirror part 12 and the first actuator 14 tilt and oscillate in opposite phases around the first axis since a high Q value can be obtained.

However, the present disclosure is not limited to the above mode. The order mode of the resonance mode to be used may be set appropriately.

Further, as the second resonance mode in which the first actuator 14 and the mirror part 12 integrally tilts and oscillates around the second axis, in the resonance mode in which the first actuator 14 and the second actuator 16 oscillate in opposite phases, the Q value of the resonance oscillation is higher and the resonance frequency is higher than that in the resonance mode in which the mirror part 12 and the first actuator 14 oscillate in the same phase. As a result, it is suitable that scanning is performed at high speed. For example, in the configuration of Example 1 described later, the resonance frequency of the in-phase resonance mode around the second axis was 4.7 kHz, and the Q value was 250. On the other hand, the resonance frequency of the resonance mode having the opposite phase around the second axis was 11 kHz, and the Q value was 940. Therefore, it is also preferable to perform driving in the lowest order mode among the resonance modes in which the first actuator 14 and the second actuator 16 tilt and oscillate in opposite phases around the second axis since a high Q value can be obtained.

However, the present disclosure is not limited to the above mode. The order mode of the resonance mode to be used may be set appropriately.

The stress distributions in the first actuator and the second actuator differ depending on which order of the resonance mode is used. Therefore, it is necessary to determine the resonance mode to be used in a case of driving and then dispose the individual electrode parts, based on the stress distribution in the resonance mode. In the present example, for the circumference of the first axis, the lowest order mode among the resonance modes in which the mirror part 12 and the first actuator 14 tilt and oscillate in opposite phases is set as the first resonance mode. For the circumference of the second axis, the lowest order mode among the resonance modes in which the first actuator 14 and the second actuator 16 tilt and oscillate in opposite phases is set as the second resonance mode.

The piezoelectric element provided in the first actuator 14 and the second actuator 16 will be described. As described above, the piezoelectric element has a laminated structure of a lower electrode 31, a piezoelectric film 32, and an upper electrode 33.

The thickness of the lower electrode and the upper electrode is not particularly limited, and is, for example, about 200 nm. The thickness of the piezoelectric film is not particularly limited as long as it is 10 $\mu$m or less, and is usually 1 $\mu$m or more, for example, 1 to 5 $\mu$m. The method for forming the lower electrode, the upper electrode and the piezoelectric film is not particularly limited, but the vapor deposition method is preferable, and the sputtering method is particularly preferable.

The main components of the lower electrode are not particularly limited, and are metals or metal oxides such as Au, Pt, Ir, $IrO_2$, $RuO_2$, $LaNiO_3$, and $SrRuO_3$, and combinations thereof.

The main component of the upper electrode is not particularly limited, and examples thereof include materials exemplified for the lower electrode, electrode materials generally used in semiconductor processes such as Al, Ti, Ta, Cr, and Cu, and combinations thereof.

Examples of the piezoelectric film include those containing one or more types of perovskite-type oxides (P) represented by the following formula.

$$\text{General formula } ABO_3 \qquad (P)$$

(In the formula, A is an element of A site, and at least one element containing Pb.

B is an element of B site, and is at least one element selected from the group consisting of Ti, Zr, V, Nb, Ta, Sb, Cr, Mo, W, Mn, Sc, Co, Cu, In, Sn, Ga, Zn, Cd, Fe, and Ni.

O is an oxygen element.

The standard molar ratio of A-site element, B-site element, and oxygen element is 1: 1: 3, but the molar ratio may deviate from the reference molar ratio within a range in which a perovskite structure can be obtained.)

Examples of the perovskite-type oxide represented by the above-mentioned general formula include lead-containing compounds such as lead titanate, lead zirconate titanate (PZT), lead zirconate tit, lead zirconate tit lanthanate, lead zirconate titanate lanthanate, lead zirconate titanate magnesium niobate, lead zirconate titanate titanate, and lead zirconate titanate zinc niobate, and mixed crystal systems thereof; lead-free compounds such as barium titanate, strontium barium titanate, bismas sodium niobate, potassium niobate potassium, niobate, sodium, potassium niobate, lithium niobate, and bismas ferrite, and mixed crystal systems thereof.

Further, the piezoelectric film of the present embodiment preferably contains one kind or two or more kinds of perovskite-type oxides (PX) represented by the following formula.

$$A_a(Zr_x, Ti_y, M_{b-x-y})_bO_c \qquad (PX)$$

(In the formula, A is an element of A site, and at least one element containing Pb. M is at least one element selected from a group which consists of V, Nb, Ta, and Sb. $0<x<b$, $0<y<b$, $0\leq b-x-y$, and a: b: c = 1: 1: 3 are standard, but these molar ratios may deviate from the reference molar ratio within the range where a perovskite structure can be obtained.)

The piezoelectric film consisting of the perovskite-type oxide represented by the above general formulas (P) and (PX) has a high piezoelectric strain constant ($d_{31}$ constant). Therefore, the piezoelectric actuator comprising such a piezoelectric film is excellent in displacement characteristics. The perovskite-type oxide represented by the general formula (PX) has a higher piezoelectric constant than that represented by the general formula (P).

Further, the piezoelectric actuator comprising the piezoelectric film which consists of the perovskite-type oxide represented by the general formulas (P) and (PX) has a voltage-displacement characteristic with excellent linearity in the driving voltage range. These piezoelectric materials exhibit favorable piezoelectric properties in carrying out the present disclosure.

[Second Embodiment]

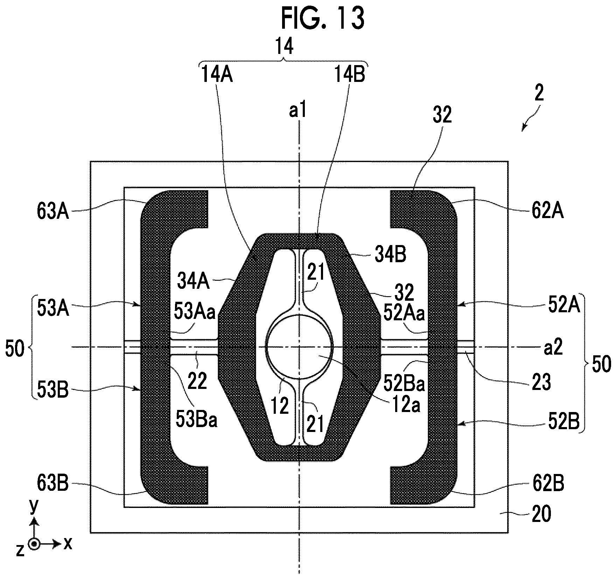

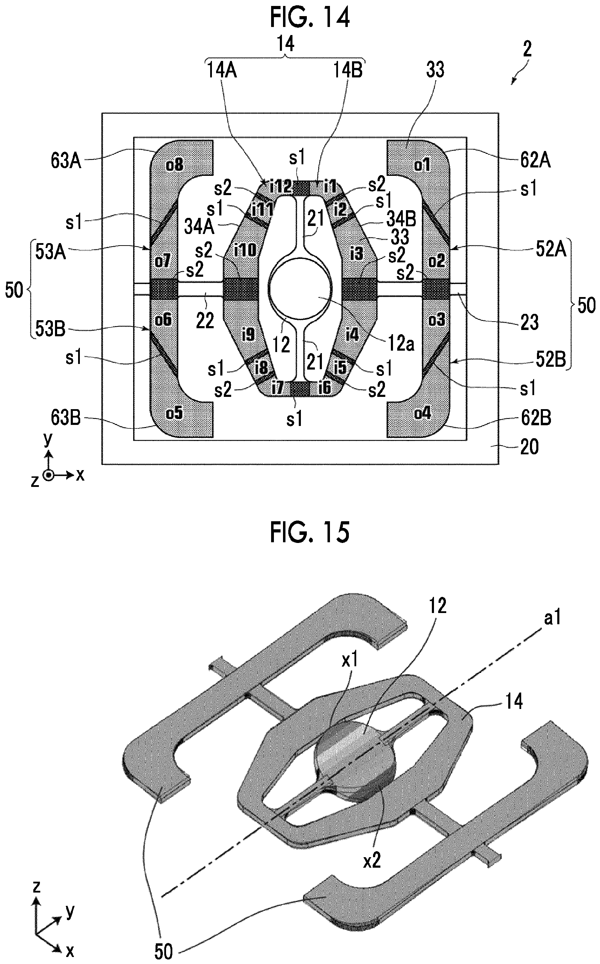

Figs. 13 and 14 are plan views of the micromirror device 2 in accordance with the second embodiment as viewed from the reflecting surface side of the mirror part. Fig. 13 shows a piezoelectric film formation region by a dark-colored hatched part. Fig. 14 is a drawing showing the upper electrode formation region by the light-colored hatched part. The elements equivalent to the micromirror device 1 of the first embodiment are designated by the same reference numerals, and detailed description thereof will be omitted.

The micromirror device 2 of the present embodiment has a different shape of the second actuator from the micromirror device 1 of the first embodiment. In the first embodiment, the second actuator 16 is an annular member disposed so as to surround the first actuator 14. However, the second actuator 50 of the present embodiment comprises second movable parts 52A and 52B and third movable parts 53A and 53B disposed exterior to the first actuator 14 which are line-symmetric around the first axis a1.

As shown in Figs. 13 and 14, the second actuator 50 includes the pair of plate-shaped second movable parts 52A and 52B and the pair of plate-shaped third movable parts 53A and 53B. Then, the second connecting part 22 connects one 14A of the pair of first movable parts 14A and 14B and one ends 53Aa and 53Ba of the pair of third movable parts 53A and 53B on the second axis a2, and connects the other 14B of the first movable parts 14A and 14B and one ends 52Aa and 52Ba of the pair of second movable parts 52A and 52B on the second axis a2. In the present embodiment, the second movable parts 52A and 52B and the third movable parts 53A and 53B function as a cantilever fixed on the second axis a2.

Piezoelectric elements 62A, 62B, 63A, and 63B are comprised in each of the second movable parts 52A and 52B and the third movable parts 53A and 53B of the second actuator 50, and function as piezoelectric actuators. The configuration of the piezoelectric actuator is the same as that of the first embodiment, and has a laminated structure in which the lower electrode 31, the piezoelectric film 32, and the upper electrode 33 are laminated in this order on the oscillation plate 30 which is the base material of the movable part.

As shown in Fig. 14, the placement of the individual electrode parts i1 to i12 in the first movable part 14A and the first movable part 14B of the first actuator 14 is the same as that in the case of the first embodiment.

On the other hand, as shown in Fig. 14, the upper electrode 33 of the piezoelectric element 62A in the second movable part 52A of the second actuator 50 consists of two individual electrode parts o1 and o2. Similarly, the upper electrode 33 of the piezoelectric element 62B in the second movable part 52B of the second actuator 50 includes two individual electrode parts o3 and o4.

The upper electrode 33 of the piezoelectric element 63A in the third movable part 53A of the second actuator 50 consists of two individual electrode parts o7 and o8. Similarly, the upper electrode 33 of the piezoelectric element 63B in the third movable part 53B of the second actuator 50 includes two individual electrode parts o5 and o6.

The individual electrode parts i1 to i12 and o1 to o8 each are separated by a first stress inversion region s1 and a second stress inversion region s2. In the first stress inversion region s1, positive and negative of a principal stress component having a maximum absolute value among principal stresses are inverted in a principal stress generated in an in-plane direction of the piezoelectric film in a case of driving in a first resonance mode in which the mirror part 12 tilts and oscillates around the first axis a1. In the second stress inversion region, positive and negative of a principal stress component having a maximum absolute value among principal stresses are inverted in a principal stress generated in the in-plane direction of the piezoelectric film in a case of driving in a second resonance mode in which the mirror part is tilted and displaced around the second axis a2.

Fig. 15 is a diagram schematically showing how the mirror part 12 tilts and oscillates around the first axis a1 in the first resonance mode, and shows a state in which one end x1 of the mirror part 12 in the x-axis direction around the first axis a1 is tilted and displaced in the +z direction and the other end x2 thereof in the x-axis direction is tilted and displaced in the -z direction. In Fig. 15, the shade of color indicates the amount of displacement.

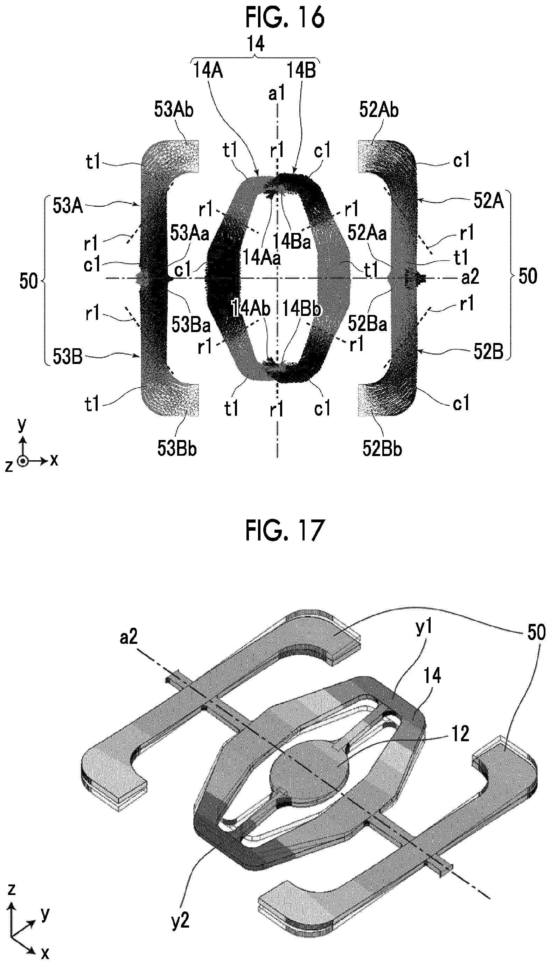

In a case where the mirror part 12 tilts and oscillates around the first axis a1 in the first resonance mode and is tilted and displaced as shown in Fig. 15, the first actuator 14 and the second actuator 50 bend and deform. Then, as shown in Fig. 16, the piezoelectric films of the first actuator 14 and the second actuator 50 have the tensile stress region t1 to which a tensile stress is applied and the compressive stress region c1 to which a compressive stress is applied. In Fig. 16, the part to which the tensile stress is applied is shown in light gray, and the part to which the compressive stress is applied is shown in black. It should be noted that the higher the color density is, the larger the stress is. In addition, Fig. 16 shows the state of in-plane stress generated in the piezoelectric film at the time when the oscillation amplitude in a case of driving in the first resonance mode is maximized.

As shown in Fig. 16, in the first movable part 14A of the first actuator 14, the region including one end 14Aa adjacent to the second movable part 14B across the first axis a1 and the region including the other end 14Ab are the tensile stress regions, and the central region including the second axis a2 between the two tensile stress regions t1 is the compressive stress region c1. In the second movable part 14B of the first actuator 14, the region including one end 14Ba and the region including the other end 14Bb adjacent to the first movable part 14A across the first axis a1 are the compressive stress regions c1, and the central region including the second axis a2 between the two compressive stress regions c1 is the tensile stress region t1. In the first resonance mode, stress distribution in the first actuator 14 is axisymmetric with respect to the second axis a2.

Further, in one of the second movable parts 52A and the other second movable part 52B of the second actuator 50, the region including one ends 52Aa and 52Ba connected on the second axis a2 is the tensile stress region t1, and the region including the other end 52Ab and the region including the other end 52Bb are the compressive stress regions c1. In one third movable part 53A and the other third movable part 53B of the second actuator 50, the region including one ends 53Aa and 53Ba connected on the second axis a2 is the compressive stress region c1, and the region including the other end 53Ab and the region including the other end 53Bb are the tensile stress regions t1. In the first resonance mode, stress distribution in the second actuator 50 is axisymmetric with respect to the second axis a2.

At the boundary between the compressive stress region c1 and the tensile stress region t1, the first stress inversion region is present, which is a region where the direction of stress gradually changes, that is, a region where the positive and negative of the principal stress component having the maximum absolute value is inverted. The stress inversion line r1 shown in Fig. 16 is located at the center of the first stress inversion region.

Fig. 17 is a diagram schematically showing a situation in which the mirror part 12 and the first actuator 50 tilt and oscillate around the second axis a2 in the second resonance mode, and shows a state in which one end y1 in the y-axis direction of the first actuator 14 is tilted and displaced in the +z direction and the other end y2 in the y-axis direction is tilted and displaced in the -z direction with respect to the second axis a2 as a center of the mirror part 12 and the first actuator 14. Similarly to Fig. 15, in Fig. 17, the shade of color indicates the amount of displacement.

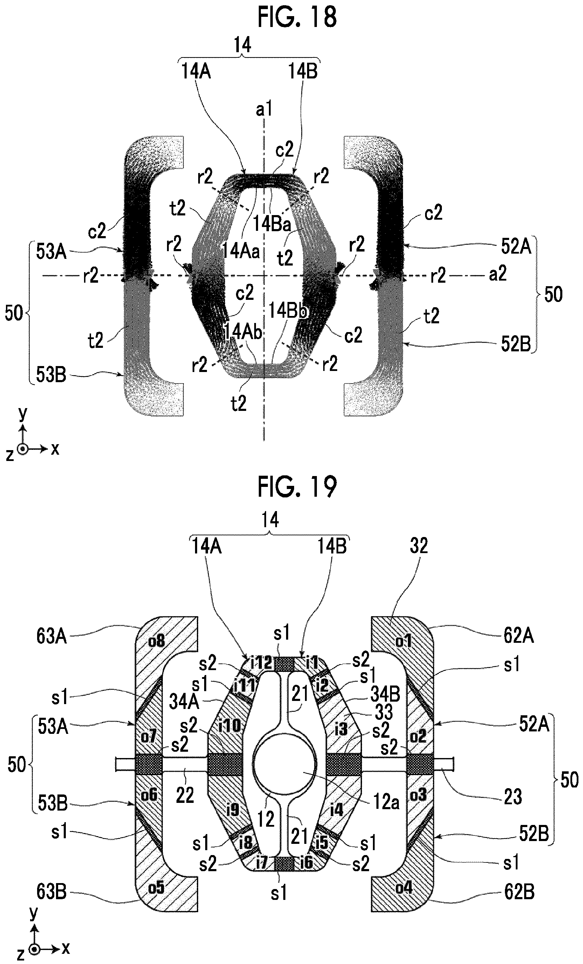

In the second resonance mode, in a case where the mirror part 12 and the first actuator 14 are tilted and oscillated around the second axis a2 and are tilted and displaced as shown in Fig. 17, the first actuator 14 and the second actuator 50 bend and deform. Then, as shown in Fig. 18, the piezoelectric films of the first actuator 14 and the second actuator 50 have a tensile stress region t2 to which a tensile stress is applied and a compressive stress region c2 to which a compressive stress is applied. In Fig. 18, similarly to Fig. 16, the part where the tensile stress is generated is shown in light gray, and the part where the compressive stress is generated is shown in black. It should be noted that the higher the color density is, the larger the stress is. In addition, Fig. 18 shows the state of in-plane stress generated in the piezoelectric film at the time when the oscillation amplitude in a case of driving in the second resonance mode is maximized.

As shown in Fig. 18, the region including each of one end 14Aa and one end 14Ba connected by the first connecting part of one of the first movable part 14A and the first movable part 14B of the first actuator 14 is the compressive stress region c2, and the region including the other ends 14Ab and 14Bb connected by the first connecting part of the other thereof is the tensile stress region t2. Further, the parts between the end regions of each of the first movable part 14A and the first movable part 14B are a tensile stress region t2 on the upper side of the paper surface and a compressive stress region c2 on the lower side of the paper surface with the second axis a2 set as a boundary. In the second resonance mode, stress distribution in the first actuator 14 is axisymmetric with respect to the first axis a1.

Further, the second movable part 52A of the second actuator 50 has a compressive stress region c2, the second movable part 52B has a tensile stress region t2, the third movable part 53A has a compressive stress region c2, and the third movable part 53B has a tensile stress region t2. In the second resonance mode, stress distribution in the second actuator 50 is also line-symmetric with respect to the first axis a1.

There is a second change region, which is a region where the direction of stress gradually changes at the boundary between the compressive stress region c2 and the tensile stress region t2, that is, the principal stress component having the maximum absolute value changes from positive to negative. In Fig. 18, the stress inversion line r2 is located at the center of the second change region.

The individual electrode parts of the upper electrodes are formed so as to correspond to stress distributions shown in Figs. 16 and 18 and to correspond to division of the piezoelectric film regions t1, c1, t2, and c2 having different stress directions. Each individual electrode part is separated by a first stress inversion region s1 including the stress inversion line r1 and a second stress inversion region s2 including the stress inversion line r2 (refer to Fig. 14).

As described above, in a case where the shape of the actuator is different, stress distribution during operation due to the resonance mode oscillation is different. However, individual electrode parts may be formed in accordance with each stress distribution. In the first actuator 14 and the second actuator 16, by disposing the piezoelectric parts in accordance with the parts having different generated stress directions, an appropriate driving signal can be input to each of them. Therefore, the piezoelectric force can be efficiently converted into a displacement.

Also in the configuration of the present embodiment, in a case of driving, in the placement form of the piezoelectric parts divided as described above, a driving voltage having the same phase is applied to the piezoelectric parts corresponding to the regions having the same stress direction of the stresses generated in the first resonance mode in which the mirror part tilts and oscillates around the first axis. That is, a driving voltage having the same phase is applied to the piezoelectric parts located in the compressive stress region, and a driving voltage having the same phase is applied to the piezoelectric parts located in the tensile stress region. Then, different driving signals are applied between the pressure parts corresponding to the regions having the different stress directions.

Thereby, a positive voltage is applied to the region where the principal stress component having the maximum absolute value is positive, and a negative voltage is applied to the region where the principal stress component having the maximum absolute value is negative. In such a manner, piezoelectric force can be very efficiently converted into displacement. Consequently, it is possible to significantly reduce power consumption.

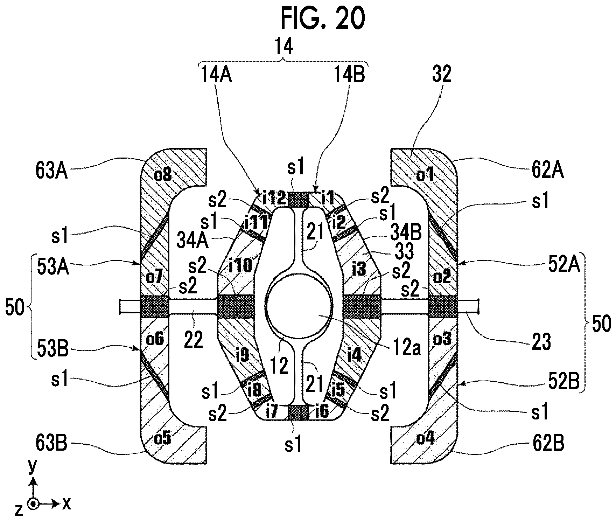

An example of the driving method will be specifically described with reference to Figs. 19 to 20. Fig. 19 is a diagram showing a piezoelectric part group to which a driving signal having the same phase is input in a case where the first resonance mode is excited. Fig. 20 is a diagram showing a piezoelectric part group to which a driving signal having the same phase is input in a case where the second resonance mode is excited. The driving signal is the same as that of the first embodiment shown in Figs. 10 and 12.

In Fig. 19, the individual electrode parts of the piezoelectric parts of the first group to which driving signals having the same phase are input in a case where the first resonance mode is excited are indicated by diagonal right downward lines. Further, the individual electrode parts of the piezoelectric parts of the second group to which the driving signal having the opposite phase to that of the first group is input are indicated by diagonal right upward lines.

The individual electrode parts i1, i2, i5, i6, i9, i10, and o1, o4, o6, o7 of the first group correspond to the compressive stress regions c1 of Fig. 16, and the first driving signal $V_1a$ for the first resonance mode having the same phase shown in Fig. 10 is input to the individual electrode parts. The individual electrode parts i3, i4, i7, i8, i11, i12, and o2, o3, o5, o8 of the second group correspond to the tensile stress regions t1 in Fig. 16, and the first driving signal $V_1b$ for the first resonance mode having the same phase is input to the individual electrode parts. As shown in Fig. 10, the driving signal $V_1a$ applied to the piezoelectric parts of the first group and the driving signal $V_1b$ applied to the piezoelectric parts of the second group have the same first frequency fi and are signals having opposite phases (phase difference 180°). By applying such a driving signal, a distortion that tilts the first actuator 14 around the first axis a1 is generated. As a result, a rotational torque around the first axis a1 is given to the mirror part 12.

In Fig. 20, the individual electrode parts of the piezoelectric parts of the third group to which the driving signals having the same phase are input in a case where the second resonance mode is excited are indicated by diagonal right downward lines. Further, the individual electrode parts of the piezoelectric parts of the fourth group to which the driving signal having the opposite phase to that of the third group is input are indicated by diagonal right upward lines.

The individual electrode parts i1, i4, i5, i8, i9, i12, and o1, o2, o7, o8 of the third group correspond to the compressive stress regions c2 of Fig. 18, and the second driving signal $V_2a$ for the second resonance mode having the same phase shown in Fig. 12 is input to the individual electrode parts. The individual electrode parts i2, i3, i6, i7, i10, i11, and o3, o4, o5, o6 of the fourth group correspond to the tensile stress regions t2 in Fig. 18, and the driving signal $V_2b$ for the second resonance mode having the same phase is input to the individual electrode parts. As shown in Fig. 12, the driving signals $V_2a$ and $V_2b$ have the same second frequency $f_2$ and are signals having opposite phases (phase difference 180°). By applying such a driving signal, a distortion that tilts the first actuator 14 around the second axis a2 is generated. As a result, a rotational torque around the second axis a2 is given to the mirror part.

Table 2 shows the combinations applied to each piezoelectric part.

[Table 2]

| Individual electrode part | 1-dimensional scanning (around first axis) | 1-dimensional scanning (around second axis) | 2-dimensional scanning (around first and second axes) |
|---|---|---|---|
| xy | first driving signal | second driving signal | driving signal |
| i1 | $V_1a$ | $V_2a$ | $V_1a+V_2a$ |

(continued)

| Individual electrode part | 1-dimensional scanning | 1-dimensional scanning | 2-dimensional scanning |
| --- | --- | --- | --- |
| | (around first axis) | (around second axis) | (around first and second axes) |
| xy | first driving signal | second driving signal | driving signal |
| i2 | $V_1a$ | $V_2b$ | $V_1a+V_2b$ |
| i3 | $V_1b$ | $V_2b$ | $V_1b+V_2b$ |
| i4 | $V_1b$ | $V_2a$ | $V_1b+V_2a$ |
| i5 | $V_1a$ | $V_2a$ | $V_1a+V_2a$ |
| i6 | $V_1a$ | $V_2b$ | $V_1a+V_2b$ |
| i7 | $V_1b$ | $V_2b$ | $V_1b+V_2b$ |
| i8 | $V_1b$ | $V_2a$ | $V_1b+V_2a$ |
| i9 | $V_1a$ | $V_2a$ | $V_1a+V_2a$ |
| i10 | $V_1a$ | $V_2b$ | $V_1a+V_2b$ |
| ill | $V_1b$ | $V_2b$ | $V_1b+V_2b$ |
| i12 | $V_1b$ | $V_2a$ | $V_1b+V_2a$ |
| o1 | $V_1a$ | $V_2a$ | $V_1b+V_2a$ |
| o2 | $V_1b$ | $V_2a$ | $V_1b+V_2a$ |
| o3 | $V_1b$ | $V_2b$ | $V_1b+V_2b$ |
| o4 | $V_1a$ | $V_2b$ | $V_1a+V_2b$ |
| o5 | $V_1b$ | $V_2b$ | $V_1b+V_2b$ |
| o6 | $V_1a$ | $V_2b$ | $V_1a+V_2b$ |
| o7 | $V_1a$ | $V_2a$ | $V_1a+V_2a$ |
| o8 | $V_1b$ | $V_2a$ | $V_1b+V_2a$ |

Also in the micromirror device 2 of the present embodiment, the driving signal applied to each piezoelectric part xy can be represented by the general Expression (1). Also In such a case, $\alpha1$ and $\alpha2$ may be different for each piezoelectric part. By increasing the voltage amplitude as the magnitude of the stress generated in the individual electrode part increases, it is possible to further increase the drive efficiency and further reduce the power consumption.

[Example of Design Change]

In the micromirror device of the present disclosure, the shapes of the first actuator, the second actuator, and the first to third connecting parts are not limited to those of the first and second embodiments. As described above, the first actuator may have a shape and placement capable of tilting and oscillating the mirror part around the first axis, and the second actuator may have a shape and placement capable of integrally tilting and oscillating the mirror part and the first actuator around the second axis.

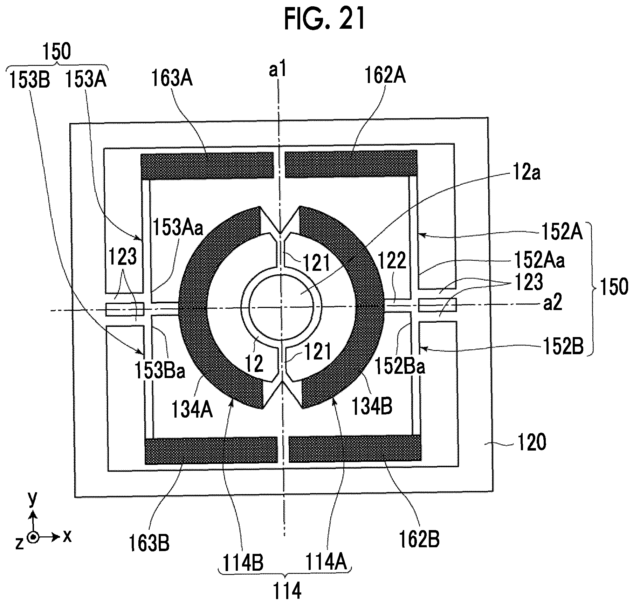

For example, Fig. 21 shows a schematic plan view of the micromirror device of the design change example. In Fig. 21, the hatched region shows a region comprising a piezoelectric film. The first actuator 114 comprises two semi-annular first movable parts 114A and 114B. The first connecting part 121 has a part which is bifurcated at a connecting part with the first movable part 114A and the first movable part 114B.

The second actuator 150 comprises second movable parts 152A and 152B and third movable parts 153A and 153B disposed exterior to the first actuator 114 line-symmetrically with respect to the first axis a1.

As shown in Fig. 21, the second actuator 150 includes a pair of L-shaped second movable parts 152A and 152B and a pair of L-shaped third movable parts 153A and 153B. Then, the second connecting part 122 connects one 114A of the pair of first movable parts and one ends 152Aa and 152Ba of the pair of second movable parts 152A and 152B on the second axis a2, and connects the other 114B of the first movable parts and one ends 152Aa and 152Ba of the pair of third movable parts 153A and 153B on the second axis a2.

The second movable parts 152A and 152B and the third movable parts 153A and 153B of the second actuator 150 each have an L-shape consisting of a part including one end connected to the second connecting part 122 and extending in the y direction and a part extending in the x direction from the other end in the y direction. The part extending in the y direction is thinner than the part extending in the x direction, and this region does not comprise a piezoelectric element. The part extending in the x direction is wider than the part extending in the y direction, and only this region includes the piezoelectric elements 162A, 162B, 163A, and 163B.

Further, in the third connecting part 123 that connects the fixing unit 120 and the second actuator 50, two pairs of rod-like members disposed in parallel with the second axis a2 interposed therebetween are disposed to face each other with the second actuator interposed therebetween.

As in the case of each of the above embodiments, the upper electrode of each piezoelectric element may be composed of a plurality of individual electrode parts, each of which is separated by a first stress inversion region and a second stress inversion. In the first stress inversion region, a principal stress component having a maximum absolute value changes from positive to negative in a principal stress generated in an in-plane direction of the piezoelectric film in a maximum displacement state in a case of driving in a first resonance mode in which the mirror part is tilted and displaced around the first axis. In the second stress inversion region, a principal stress component having a maximum absolute value changes from positive to negative in a principal stress generated in the in-plane direction of the piezoelectric film in a case of driving in a second resonance mode in which the mirror part is tilted and displaced around the second axis.

As described above, in the present disclosure, the shapes of the first actuator provided exterior to the mirror part and the second actuator provided exterior to the first actuator are not particularly limited. The individual electrode parts are provided which correspond to the direction of the principal stress component having the maximum absolute value in the principal stresses generated in a case where driving the first resonance mode and the second resonance mode, depending on the configuration of the mirror part, the first actuator, the second actuator and their connecting parts. In such a case, it is possible to input a driving signal having high conversion efficiency, and it is possible to effectively suppress power consumption.

Examples

Hereinafter, the micromirror devices of examples of the present disclosure will be described.

[Example 1]

The micromirror device having the configurations shown in Figs. 1 to 4 was manufactured as Example 1 by the following procedure.

-Manufacturing Method-

(Step 1) A Ti layer with 30 nm was formed and an Ir layer with 150 nm was formed, at a substrate temperature of 350°C, by a sputtering method, on an silicon on insulator (SOI) substrate having a laminated structure of a Si handle layer 350 $\mu$m, a silicon oxide (SiO$_2$) box layer 1 $\mu$m, and a Si device layer 100 $\mu$m. The laminated structures of the Ti layer and the Ir layer correspond to the lower electrode 31 in Fig. 4.

(Step 2) A piezoelectric film with 3 $\mu$m was formed on the substrate on which the Ti/Ir lower electrodes obtained above were laminated and formed using a radio frequency (RF) sputtering device. As the target material for sputtering film formation for the piezoelectric film, a material having a composition of $Pb_{1.3}$ $((Zr_{0.52} Ti_{0.48})_{0.88}Nb_{0.12})$ $O_3$ was used. The film forming pressure was 2.2 mTorr, and the film forming temperature was 450°C. The obtained piezoelectric film was an Nb-doped PZT thin film to which Nb was added at an atomic composition ratio of 12%.

(Step 3) An upper electrode including the plurality of individual electrode parts using a Pt/Ti laminated structure was patterned by a lift-off method, on the substrate on which the piezoelectric film obtained above was formed.

(Step 4) After that, the piezoelectric film and the lower electrode were pattern-etched by inductively coupled plasma (ICP) dry etching.

(Step 5) Further, an insulating layer consisting of SiO$_2$ was formed on the entire surface by a chemical vapor deposition method (TEOS-CVD: tetraethoxysilane-chemical vapor deposition) using tetraethoxysilane as a raw material, and then the insulating layer was patterned by the ICP dry etching.

(Step 6) A laminated structure of Au/Ti was formed into a pattern, and a reflecting surface of a mirror part, an electrode pad, and a wiring layer were formed, by the lift-off method.

(Step 7) The device layer was pattern-etched by a silicon dry etching process to process the shapes of the actuator, the mirror part, and the fixing member.

(Step 8) Next, the handle layer was subject to deep-drilled reactive ion etching from the back surface of the substrate. Basically, the handle layer was removed such that a part to be a fixing member remains.

(Step 9) Finally, the micromirror device 1 described with reference to Figs. 1 to 4 was manufactured by removing the box layer from the back surface by dry etching.

In the above manufacturing step, the reflecting surface of the mirror part is formed in Step 6, but the reflecting surface may be formed by using a reflective material different from the material of the electrode pad and the wiring layer. In that case, for example, subsequently to Step 6, the reflecting surface may be formed by a lift-off method or the like.

In carrying out the present disclosure, the present disclosure is not limited to the configuration and manufacturing method of Example 1, and the substrate material, electrode material, piezoelectric material, film thickness, film forming conditions, and the like may be appropriately selected in accordance with the purpose.

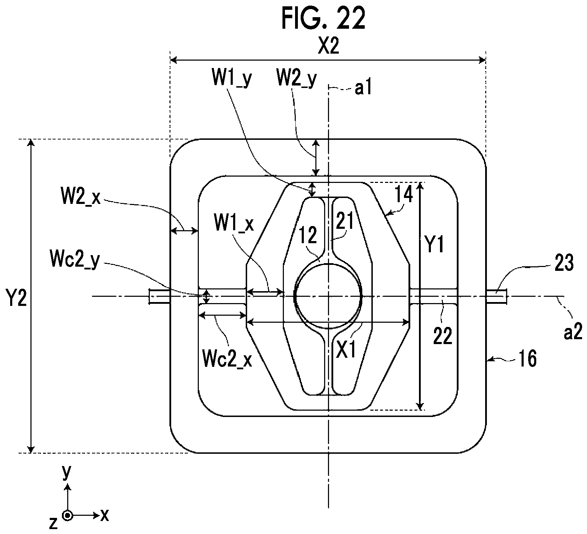

Various dimensions of the micromirror device of the present example are specified as shown in Fig. 22. The length of the first actuator 14 in the x-axis direction (second axis direction) is X1, the length thereof in the y-axis direction (first axis direction) is Y1, the width thereof in the x-axis direction is W1_x, and the width thereof in the y-axis direction is W1_y. The length of the second actuator 16 in the x-axis direction is X2, the length in the y-axis direction is Y2, the width in the x-axis direction is W2_x, and the width in the y-axis direction is W2_y. The length of the second connecting part 22 in the x-axis direction is Wc2_x and the width in the y-axis direction is Wc2_y.

Various dimensions in Example 1 were as follows.

A mirror shape was a circular with a diameter of 1.1 mm,

first actuator dimensions were X1 = 2.67 mm, Y1 = 3.77 mm, W1_x = 0.6 mm, and W1_y = 0.25 mm,
second actuator dimensions were X2 = 5.17 mm, Y2 = 5.17 mm, W2_x = 0.45 mm, and W2_y = 0.6 mm,
second connecting part were Wc2_x = 0.8 mm, and Wc2_y = 0.238 mm, and
the thickness of the device layer was td = 0.1 mm.

The thicknesses of the mirror part 12, the first actuator 14, the second actuator 16, and the first connecting part 21, the second connecting part 22, and the third connecting part 23 are equal to the thickness of the device layer.

In the micromirror device having this configuration, the dimensions of the first connecting part 21 and the third connecting part 23 were set such that the frequency of the first resonance mode was about 60 kHz and the frequency of the second resonance mode was about 10 kHz.

The stress distribution during operation using resonance mode oscillation (resonance drive) was analyzed by parameters such as the device dimensions, Young's modulus of material, and device shape given using the known finite element method software through the mode analysis method. The stress distributions in each of the first resonance mode and the second resonance mode were obtained (refer to Figs. 6 and 8), and the upper electrodes were divided into individual electrode parts in accordance with stress distributions. Here, the electrode distribution placement shown in Fig. 3 was adopted.

[Example 1-1]

The driving signal, in which a second driving signal having a frequency coinciding with that in the second resonance mode is superimposed on a first driving signal having a frequency coinciding with that in the first resonance mode, was applied to each piezoelectric part of the micromirror device according to Example 1 mentioned above.

The voltage Vxy represented by Expression (1) was applied thereto.

$$\mathrm{Vxy} = \alpha_1 V_1 \sin(2\pi f_1 t + \beta_1 \pi) + \alpha_2 V_2 \sin(2\pi f_2 t + \beta_2 \pi) \quad (1)$$

where xy is a reference sign that specifies each of the plurality of piezoelectric parts, and $V_1$, $V_2$, $\alpha_1$, $\alpha_2$, $\beta_1$, $\beta_2$, $f_1$, $f_2$, and t are values which are set for each piezoelectric part,
$V_1$ is a basic voltage amplitude value of the first driving signal,
$V_2$ is a basic voltage amplitude value of the second driving signal,
$\alpha_1$ is a voltage amplitude correction coefficient for the first driving signal,
$\alpha_2$ is a voltage amplitude correction coefficient for the second driving signal,
$\beta_1$ is a phase correction coefficient for the first driving signal,
$\beta_2$ is a phase correction coefficient for the second driving signal,
fi is a frequency of the first driving signal,
$f_2$ is a frequency of the second driving signal, and
t is a time.

The correction coefficients of the voltage applied to each piezoelectric part (each individual electrode part) are as shown in Table 3.

[Table 3]

| Individual electrode part | Correction coefficient for first driving signal | | Correction coefficient for second driving signal | |
|---|---|---|---|---|
| xy | $\alpha_1$ | $\beta_1$ | $\alpha_2$ | $\beta_2$ |
| i1 | 1 | 1 | 1 | 0 |
| i2 | | 1 | | 1 |
| i3 | | 0 | | 1 |
| i4 | | 0 | | 0 |
| i5 | | 1 | | 0 |
| i6 | | 1 | | 1 |
| i7 | | 0 | | 1 |
| i8 | | 0 | | 0 |
| i9 | | 1 | | 0 |
| i10 | | 1 | | 1 |
| i11 | | 0 | | 1 |
| i12 | | 0 | | 0 |
| o1 | 1 | 0 | 1 | 1 |
| o2 | | 0 | | 0 |
| o3 | | 0 | | 1 |
| o4 | | 0 | | 0 |
| o5 | | 1 | | 0 |
| o6 | | 1 | | 1 |
| o7 | | 1 | | 0 |
| o8 | | 1 | | 1 |

In Example 1-1, the correction coefficients $\alpha_1$ and $\alpha_2$ are all set to 1 in common. That is, the voltage amplitude of the first driving signal is common to all the piezoelectric parts, and the voltage amplitude of the second driving signal is common to all the piezoelectric parts.

[Example 1-2]

Regarding each piezoelectric part of the micromirror device of Example 1 mentioned above, the correction coefficient of the voltage applied to each piezoelectric part in the above Expression (1) is as shown in Table 4. As shown in Table 4, in Example 1-2, the correction coefficients $\alpha_1$ and $\alpha_2$ were changed for each position of the piezoelectric part.

[Table 4]

| Individual electrode part | Correction coefficient for first driving signal | | Correction coefficient for second driving signal | |
|---|---|---|---|---|
| xy | $\alpha_1$ | $\beta_1$ | $\alpha_2$ | $\beta_2$ |
| i1 | 0.9 | 1 | 0.7 | 0 |
| i2 | | | 0.9 | 1 |
| i3 | 1 | 0 | | |
| i4 | | | | 0 |
| i5 | 0.9 | 1 | | |
| i6 | | | 0.7 | 1 |
| i7 | | 0 | | |
| i8 | | | 0.9 | 0 |
| i9 | 1 | 1 | | |
| i10 | | | | 1 |
| i11 | 0.9 | 0 | | |
| i12 | | | 0.7 | 0 |
| o1 | 0.3 | 0 | 0.5 | 1 |
| o2 | | | 1 | 0 |
| o3 | | | | 1 |
| o4 | | 1 | 0.5 | 0 |
| o5 | | | | |
| o6 | | | 1 | 1 |
| o7 | | | | 0 |
| o8 | | | 0.5 | 1 |

Table 5 shows a standardized average in-plane stress for each region corresponding to each individual electrode part for the principal stress component having the maximum absolute value generated in the first and second actuators in a case where the mirror part is maximally displaced during each driving in the first resonance mode and the second resonance mode. In Example 1-2, the correction coefficients $\alpha_1$, $\beta_1$ and $\alpha_2$ and $\beta_2$ were set in each individual electrode part in accordance with the magnitude of the average in-plane stress generated in each individual electrode part region shown in Table 5 (refer to Table 4).

[Table 5]

| Individual electrode part | Average in-plane stress in first resonance mode (after standardization) | Average in-plane stress in second resonance mode (after standardization) |
|---|---|---|
| xy | | |
| i1 | -0.9 | 0.7 |
| i2 | | -0.9 |
| i3 | 1 | |
| i4 | | 0.9 |
| i5 | -0.9 | |
| i6 | | -0.7 |
| i7 | 0.9 | |
| i8 | | 0.9 |
| i9 | -1 | |
| i10 | | -0.9 |
| i11 | 0.9 | |
| i12 | | 0.7 |
| o1 | | -0.5 |
| o2 | 0.3 | 1 |
| o3 | | -1 |
| o4 | | 0.5 |
| o5 | | |
| o6 | -0.3 | -1 |
| o7 | | 1 |
| o8 | | -0.5 |

[Reference Example 1]

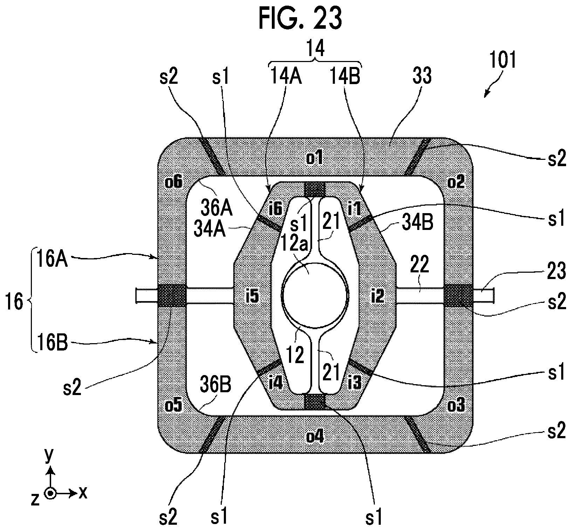

Fig. 23 shows a front view of the micromirror device 101 of Reference Example 1. The micromirror device 101 of Reference Example 1 differs from Example 1 only in the placement of the individual electrode parts of the upper electrodes. The same components as in Example 1 are represented by the same reference numerals. The micromirror device of Reference Example 1 was manufactured by the same manufacturing procedure as in Example 1. In Reference Example 1, the first actuator 14 is configured to be responsible only for driving the tilt oscillation around the first axis, and the second actuator 16 is configured to be responsible only for driving the tilt oscillation around the second axis. The pair of first movable parts 14A and 14B of the first actuator 14 comprises a total of six individual electrode parts i1 to i6. The individual electrode parts i1 to i6 are provided in accordance with the positive and negative of the principal stress component having the maximum absolute value in the principal stresses generated in the first actuator in the first resonance mode shown in Fig. 6, and are separated only by the first stress inversion region s1. In the second actuator 16, the pair of second movable parts 16A and 16B comprises a total of six individual electrode parts o1 to o6. The individual electrode parts o1 to o6 are provided in accordance with the positive and negative of the principal stress component having the maximum absolute value in the principal stresses generated in the second actuator 16 in the second resonance mode shown in Fig. 8, and are separated only by the second stress inversion region s2.

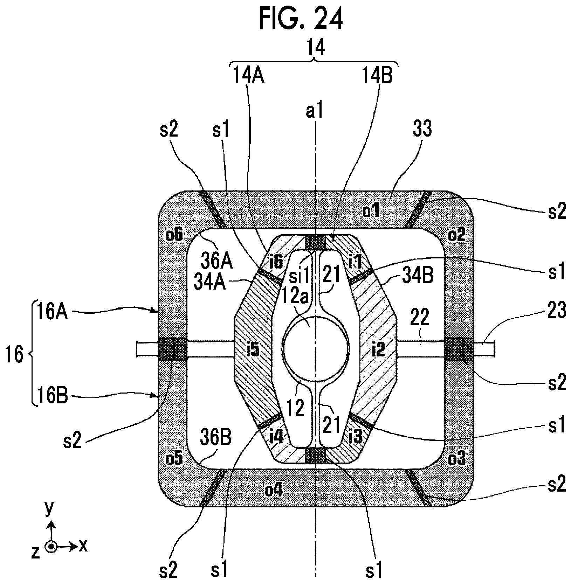

In Fig. 24, in a case where the first resonance mode is excited, in the first actuator 14, the individual electrode parts driven in the same phase are indicated by the same diagonal lines. In Fig. 24, the individual electrode parts i2, i4, and i6 indicated by the diagonal right upward lines correspond to the tensile stress regions t1 in Fig. 6. In Fig. 24, the individual electrode parts i1, i3, and i5 indicated by the diagonal right downward lines correspond to the compressive stress regions c1 in Fig. 6. A first driving signal for the first resonance mode having opposite phases is applied between the individual electrode parts corresponding to the tensile stress regions t1 and the individual electrode parts corresponding to the compressive stress regions c1.

Only the first actuator 14 is used to excite the first resonance mode, and the second actuator 16 is not used.

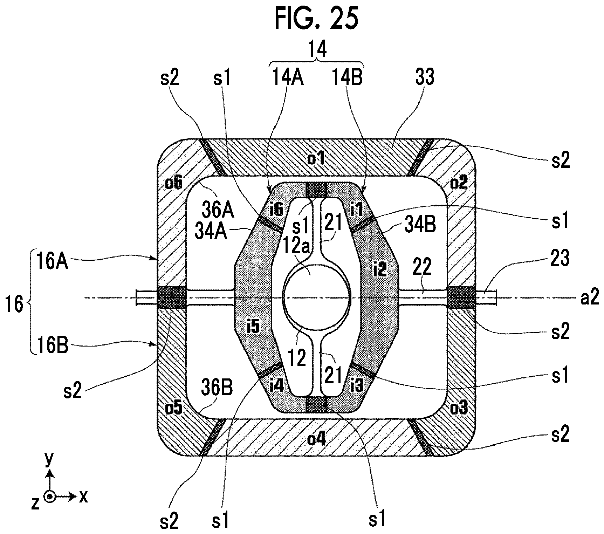

On the other hand, in Fig. 25, in a case where the second resonance mode is excited, in the second actuator 16, the individual electrode parts driven in the same phase are indicated by the same diagonal lines. In Fig. 25, the individual electrode parts o2, o4, and o6 indicated by the diagonal right upward lines correspond to the tensile stress regions t2 in Fig. 8. In Fig. 25, the individual electrode parts o1, o3, and o5 indicated by the diagonal right downward lines correspond to the compressive stress regions c2 in Fig. 8. A second driving signal for the second resonance mode having opposite phases is applied between the individual electrode parts corresponding to the tensile stress regions t2 and the individual electrode parts corresponding to the compressive stress regions c2.

Only the second actuator 16 is used to excite the second resonance mode, and the first actuator 14 is not used.

That is, in Reference Example 1, only the first driving signal was input to the upper electrode of the piezoelectric element of the first actuator, and only the second driving signal was input to the upper electrode of the piezoelectric element of the second actuator. In the present example, each parameter of Expression (1) was set as shown in Table 6. Thereby, the first and second resonance modes are excited to rotate the mirror part 12 around the first axis a1, and at the same time, the first actuator 14 and the mirror part 12 are substantially integrated and rotate around the second axis a2.

[Table 6]

| Individual electrode part | Correction coefficient for first driving signal | | Correction coefficient for second driving signal | |
|---|---|---|---|---|
| xy | $\alpha_1$ | $\beta_1$ | $\alpha_2$ | $\beta_2$ |
| i1 | 1 | 1 | 0 | - |
| i2 | | 0 | | - |
| i3 | | 1 | | - |
| i4 | | 0 | | - |
| i5 | | 1 | | - |
| i6 | | 0 | | - |
| o1 | 0 | - | 1 | 1 |
| o2 | | - | | 0 |
| o3 | | - | | 1 |
| o4 | | - | | 0 |
| o5 | | - | | 1 |
| o6 | | - | | 0 |

For driving the micromirror devices of Examples 1-1 and 1-2 and Reference Example 1, driving in the first resonance mode and the second resonance mode was performed, and examination was performed on the driving voltage amplitude, which is necessary to perform scanning of 45° around the first axis a1, and the basic voltage amplitude value $V_1$ of the first driving signal, the basic voltage amplitude value $V_2$ of the second driving signal, and the power consumption, which are necessary to perform scanning of 30° around the second axis a2. Table 7 shows the results. The optical scan angle was measured in the following method. Laser is vertically incident onto the reflecting surface of the mirror part of the micromirror device, the length of the scanning line is measured using a ruler, and the like, and the total angle of scanning is calculated from the geometrical relationship.

[Table 7]

| | Voltage amplitude | Voltage amplitude | Power consumption |
|---|---|---|---|
| | $V_1$(V) | $V_2$(V) | (mW) |
| Example 1-1 | 2.5 | 3.5 | 0.43 |
| Example 1-2 | 2.2 | 2.2 | 0.28 |
| Reference Example 1 | 4.2 | 5.5 | 1.14 |

The power consumption can be calculated based on the following method. The driving voltage waveform V is a sine wave represented by $V = V_{off}+V_A\sin\omega t$. The current flowing through each upper electrode in a case of driving with this driving voltage waveform applied is measured by a current measurement circuit. Specifically, a known resistor is connected in series to the electrode to be measured, and the current flowing through each electrode is measured by measuring the voltage across the resistor. From the current waveform $I = I_{off}+I_A\sin(\omega t+\varphi)$ measured at this time and the driving voltage waveform V, the power consumption $W = V_{off}\times I_{off}+1/2\times I_A V_A\cos\varphi$ is calculated. In addition, the first term is the power consumption due to the leakage current. However, in a case where the piezoelectric film has a favorable quality, $I_{off} > 1$ μA or less, and the value is negligibly small. Therefore, the power consumption can be estimated by calculating the second term. Based on this method, the power consumption in each piezoelectric part was calculated, and the power consumption was calculated by integrating all the piezoelectric parts.

As shown in Table 7, in Example 1-1 and Example 1-2, the voltage amplitude can be significantly reduced as compared with Reference Example 1, and as a result, it is apparent that power consumption can be suppressed. Particularly, as in Example 1-2, the power consumption can be suppressed more remarkably by changing the voltage amplitude applied to the piezoelectric part in accordance with the magnitude of the principal stress component having the maximum absolute value.

[Example 2]

As Example 2, the micromirror device of the second embodiment described with reference to Figs. 13 and 14 was manufactured. The manufacturing procedure was the same as in Example 1 above. The second actuator differs from the device of Example 1 in that it is composed of two members. However, similarly, based on mode analysis using software of the finite element method, stress distribution in a case of each of the first resonance mode and the second resonance mode was obtained (refer to Figs. 16 and 18), and the upper electrodes were divided into individual electrode parts. Here, the electrode distribution placement shown in Fig. 14 was adopted.

A driving signal represented by Expression (1) was applied to each piezoelectric part of the micromirror device of Example 2 as in the case of Example 1. The correction coefficients in the driving signal applied to each piezoelectric part are as shown in Table 8.

[Table 8]

| Individual electrode part | Correction coefficient for first driving signal | | Correction coefficient for second driving signal | |
|---|---|---|---|---|
| xy | $\alpha_1$ | $\beta_1$ | $\alpha_2$ | $\beta_2$ |
| i1 | 1 | 1 | 1 | 0 |
| i2 | | 1 | | 1 |
| i3 | | 0 | | 1 |
| i4 | | 0 | | 0 |
| i5 | | 1 | | 0 |
| i6 | | 1 | | 1 |
| i7 | | 0 | | 1 |
| i8 | | 0 | | 0 |
| i9 | | 1 | | 0 |
| i10 | | 1 | | 1 |
| i11 | | 0 | | 1 |
| i12 | | 0 | | 0 |

(continued)

| Individual electrode part | Correction coefficient for first driving signal | | Correction coefficient for second driving signal | |
|---|---|---|---|---|
| xy | $\alpha_1$ | $\beta_1$ | $\alpha_2$ | $\beta_2$ |
| o1 | 1 | 1 | 1 | 0 |
| o2 | | 0 | | |
| o3 | | | | 1 |
| o4 | | 1 | | |
| o5 | | 0 | | |
| o6 | | 1 | | |
| o7 | | | | 0 |
| o8 | | 0 | | |

In Example 2, the correction coefficients $\alpha_1$ and $\alpha_2$ are all set to 1 in common. That is, the voltage amplitude of the first driving signal is common to all the piezoelectric parts, and the voltage amplitude of the second driving signal is common to all the piezoelectric parts.

[Reference Example 2]

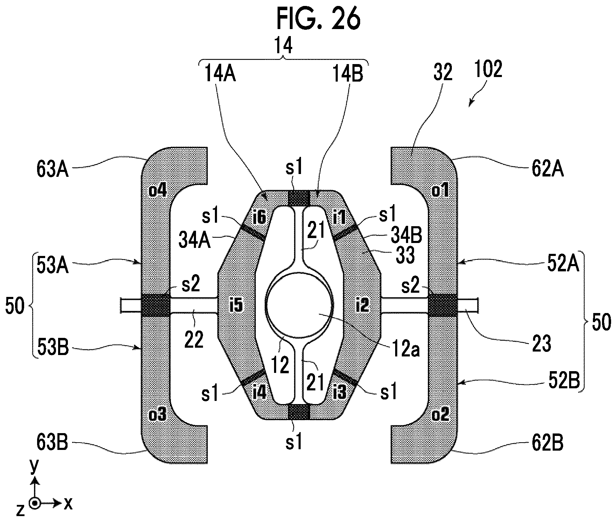

Fig. 26 shows a front view of the micromirror device 102 of Reference Example 2. The micromirror device 102 of Reference Example 2 differs from Example 2 only in the placement of the individual electrode parts of the upper electrodes. The same components as in Example 2 are represented by the same reference numerals. The micromirror device of Reference Example 2 was manufactured by the same manufacturing procedure as in Example 2. In Reference Example 2, the first actuator is configured to be responsible only for driving the tilt oscillation around the first axis, and the second actuator is configured to be responsible only for driving the tilt oscillation around the second axis. The pair of first movable parts 14A and 14B of the first actuator 14 includes a total of six individual electrode parts i1 to i6. The individual electrode parts i1 to i6 are provided in accordance with the positive and negative of the sign of the principal stress component having the maximum absolute value in the principal stresses generated in the first actuator in the first resonance mode shown in Fig. 16, and are separated only by the first stress inversion region s1. The pair of second movable parts and the pair of third movable parts of the second actuator 50 comprise four individual electrode parts o1 to o4, one for each movable part. The individual electrode parts o1 to o4 are provided in accordance with the positive and negative of the sign of the principal stress component having the maximum absolute value in the principal stresses generated in the second actuator in the second resonance mode shown in Fig. 18, and are separated only by the second stress inversion region s2.

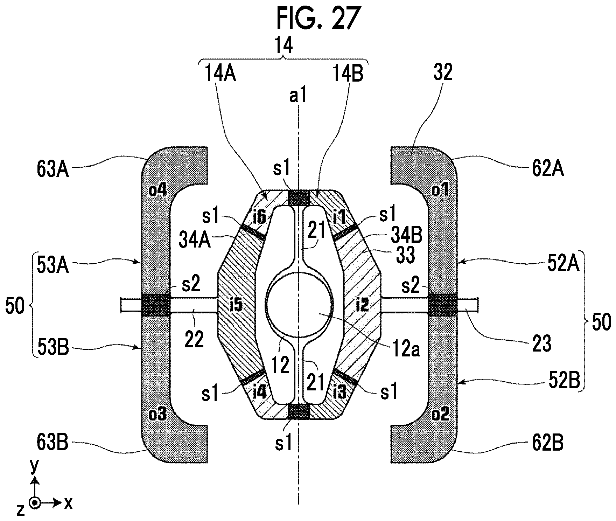

In Fig. 27, in a case where the first resonance mode is excited, in the first actuator 14, the individual electrode parts driven in the same phase are indicated by the same diagonal lines. In Fig. 27, the individual electrode parts i2, i4, and i6 indicated by the diagonal right upward lines correspond to the tensile stress regions t1 in Fig. 16. In Fig. 27, the individual electrode parts i1, i3, and i5 indicated by the diagonal right downward lines correspond to the compressive stress regions c1 in Fig. 16. A first driving signal for the first resonance mode having opposite phases is applied between the individual electrode parts corresponding to the tensile stress regions t1 and the individual electrode parts corresponding to the compressive stress regions c1.

Only the first actuator 14 is used to excite the first resonance mode, and the second actuator 50 is not used.

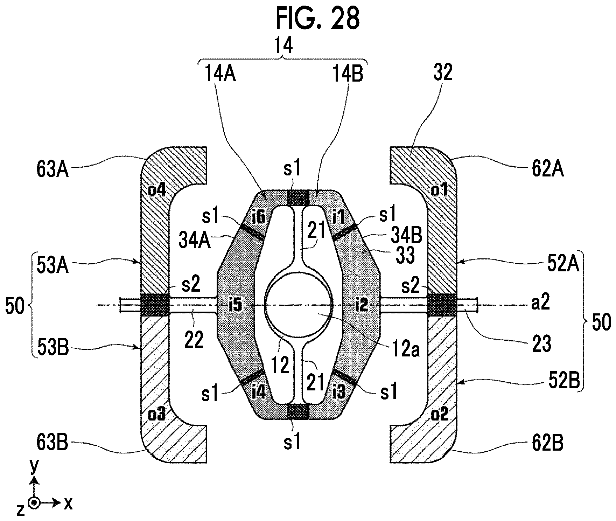

On the other hand, in Fig. 28, in a case where the second resonance mode is excited, in the second actuator 50, the individual electrode parts driven in the same phase are indicated by the same diagonal lines. In Fig. 28, the individual electrode parts o2 and o3 indicated by the diagonal right upward lines correspond to the tensile stress regions t2 in Fig. 18. In Fig. 28, the individual electrode parts o1 and o4 indicated by the diagonal right downward lines correspond to the compressive stress regions c2 in Fig. 18. A second driving signal for the second resonance mode having opposite phases is applied between the individual electrode parts corresponding to the tensile stress regions t2 and the individual electrode parts corresponding to the compressive stress regions c2.

Only the second actuator 50 is used to excite the second resonance mode, and the first actuator 14 is not used.

That is, in Reference Example 2, only the first driving signal was input to the upper electrode of the piezoelectric element of the first actuator 14, and only the second driving signal was input to the upper electrode of the piezoelectric element of the second actuator 16. In the present example, each parameter of Expression (1) was set as shown in Table 9. Thereby, the first and second resonance modes are excited to rotate the mirror part 12 around the first axis a1, and at the same time, the first actuator 14 and the mirror part 12 are substantially integrated and rotate around the second axis a2.

[Table 9]

| Individual electrode part | Correction coefficient for first driving signal | | Correction coefficient for second driving signal | |
|---|---|---|---|---|
| xy | $\alpha_1$ | $\beta_1$ | $\alpha_2$ | $\beta_2$ |
| i1 | 1 | 1 | 0 | - |
| i2 | | 0 | | - |
| i3 | | 1 | | - |
| i4 | | 0 | | - |
| i5 | | 1 | | - |
| i6 | | 0 | | - |
| o1 | 0 | - | 1 | 1 |
| o2 | | - | | 0 |
| o3 | | - | | 1 |
| o4 | | - | | 0 |

For driving the micromirror devices of Example 2 and Reference Example 2, driving in the first resonance mode and the second resonance mode was performed as in the case of Example 1 and Reference Example 1, and examination was performed on the driving voltage amplitude, which is necessary to perform scanning of 45° around the first axis a1, and the basic voltage amplitude value $V_1$ of the first driving signal, the basic voltage amplitude value $V_2$ of the second driving signal, and the power consumption, which are necessary to perform scanning of 30° around the second axis a2. Table 10 shows the results.

[Table 10]

| | Voltage amplitude | Voltage amplitude | Power consumption |
|---|---|---|---|
| | $V_1$(V) | $V_2$(V) | (mW) |
| Example2 | 2.8 | 5 | 1.25 |
| Reference Example 2 | 4.3 | 7 | 1.45 |

As shown in Table 10, in Example 2, the voltage amplitude can be significantly reduced as compared with Reference Example 2, and as a result, it is apparent that power consumption can be suppressed.
The present disclosure of JP2019-063659 filed on March 28, 2019 is incorporated herein by reference in its entirety.
All documents, patent applications, and technical standards described in the present specification are incorporated into the present specification by reference to the same extent as in a case where the individual documents, patent applications, and technical standards were specifically and individually stated to be incorporated by reference.

Claims

1.  A micromirror device comprising:

a mirror part that has a reflecting surface reflecting incident light;
a first actuator that is provided exterior to the mirror part;
a second actuator that is provided exterior to the first actuator;
a first connecting part that connects the mirror part and the first actuator and rotatably supports the mirror part on a first axis;

a second connecting part that connects the first actuator and the second actuator and rotatably supports the first actuator on a second axis intersecting the first axis; and

a third connecting part that rotatably connects the second actuator to a fixing unit provided on an outer circumference of the second actuator,

wherein the first actuator and the second actuator apply rotational torque around the first axis to the mirror part and apply rotational torque around the second axis to the mirror part and the first actuator, so as to two-dimensionally rotationally drive the mirror part around the first axis and the second axis,

wherein each of the first actuator and the second actuator is a piezoelectric actuator including a piezoelectric element in which a lower electrode, a piezoelectric film, and an upper electrode are laminated on an oscillation plate, and

wherein, in each of the piezoelectric elements, each upper electrode is formed of a plurality of individual electrode parts, each of which is separated by a first stress inversion region and a second stress inversion region, and includes a plurality of piezoelectric parts respectively defined by the plurality of individual electrode parts, wherein, in the first stress inversion region, positive and negative of a principal stress component having a maximum absolute value are inverted in a principal stress generated in an in-plane direction of the piezoelectric film in a maximum displacement state in a case of driving in a first resonance mode in which the mirror part is tilted and displaced around the first axis, and in the second stress inversion region, positive and negative of a principal stress component having a maximum absolute value are inverted in a principal stress generated in the in-plane direction of the piezoelectric film in a case of driving in a second resonance mode in which the mirror part is tilted and displaced around the second axis.

2. The micromirror device according to claim 1,
wherein the third connecting part is connected to the outer circumference of the second actuator on the second axis.

3. The micromirror device according to claim 1 or 2, wherein:

the first actuator includes a pair of first movable parts having semi-annular shapes,
the second actuator includes a pair of second movable parts having semi-annular shapes,
the first connecting part connects the mirror part and one end of each of the pair of first movable parts, and the mirror part and another end of each of the pair of first movable parts, on the first axis, and
the second connecting part connects one of the pair of first movable parts and one end of each of the pair of second movable parts, and connects another of the pair of first movable parts and the another end of each of the pair of second movable parts, on the second axis.

4. The micromirror device according to claim 1 or 2, wherein:

the first actuator includes a pair of first movable parts having semi-annular shapes,
the first connecting part connects the mirror part and one end of each of the pair of first movable parts, and the mirror part and another end of each of the pair of first movable parts, on the first axis, and
the second actuator includes a pair of plate-shaped second movable parts and a pair of plate-shaped third movable parts, and
the second connecting part connects one of the pair of first movable parts and one end of each of the pair of second movable parts, and connects another of the pair of first movable parts and one end of each of the third movable parts, on the second axis.

5. The micromirror device according to any one of claims 1 to 4, further comprising a drive circuit that inputs driving signals to the piezoelectric elements of the first actuator and the second actuator.

6. The micromirror device according to claim 5,
wherein the drive circuit inputs, to the respective piezoelectric elements of the first actuator and the second actuator, driving signals for driving the micromirror device in a first resonance mode in which the mirror part tilts and oscillates around the first axis and for driving the micromirror device and the first actuator in a second resonance mode in which the mirror part and the first actuator tilt and oscillate around the second axis.

7. The micromirror device according to claim 6,
wherein the drive circuit inputs, to each of the plurality of piezoelectric parts of each piezoelectric element, a driving signal obtained by superimposing a first driving signal and a second driving signal, wherein, in the first driving signal, a driving voltage waveform applied to a piezoelectric part located in a region where the principal stress component having the maximum absolute value is positive and a driving voltage waveform applied to a piezoelectric part located in a region where the principal stress component having the maximum absolute value is negative are in an opposite phase relationship with each other at a time when an oscillation amplitude in a case of driving in the first resonance mode is maximized, and in the second driving signal, a driving voltage waveform applied to the piezoelectric part located in a region where the principal stress component having the maximum absolute value is positive and a driving voltage waveform applied to the piezoelectric part located in a region where the principal stress component having the maximum absolute value is negative are in an opposite phase relationship with each other at a time when an oscillation amplitude in a case of driving in the second resonance mode is maximized.

8.  The micromirror device according to claim 6 or 7,
    wherein as the driving signal, the drive circuit applies a driving signal Vxy represented by Expression (1) to each of the plurality of piezoelectric parts in accordance with each placement thereof:

$$Vxy = \alpha_1 V_1 \sin(2\pi f_1 t + \beta_1 \pi) + \alpha_2 V_2 \sin(2\pi f_2 t + \beta_2 \pi) \quad (1),$$

wherein xy is a reference sign that specifies each of the plurality of piezoelectric parts, and $V_i$, $V_2$, $\alpha_1$, $\alpha_2$, $\beta_1$, $\beta_2$, $f_1$, $f_2$, and t are values which are set for each piezoelectric part,
$V_1$ is a basic voltage amplitude value of the first driving signal,
$V_2$ is a basic voltage amplitude value of the second driving signal,
$\alpha_1$ is a voltage amplitude correction coefficient for the first driving signal,
$\alpha_2$ is a voltage amplitude correction coefficient for the second driving signal,
$\beta_1$ is a phase correction coefficient for the first driving signal,
$\beta_2$ is a phase correction coefficient for the second driving signal,
$f_i$ is a frequency of the first driving signal,
$f_2$ is a frequency of the second driving signal, and
t is a time.

9.  The micromirror device according to claim 8,
    wherein the drive circuit applies the driving signal Vxy in which a value of the correction coefficient $\alpha_1$ is larger, as the piezoelectric part is located in the region where the absolute value of the principal stress component having the maximum absolute value in a case of driving in the first resonance mode is larger, and a value of the correction coefficient $\alpha_2$ is larger as the piezoelectric part is located in the region where the absolute value of the principal stress component having the maximum absolute value in a case of driving in the second resonance mode is larger.

10. The micromirror device according to claim any one of claims 6 to 9,
    wherein the first resonance mode is a lowest order mode of resonance modes in which the mirror part and the first actuator tilt and oscillate in opposite phases to each other.

11. The micromirror device according to any one of claims 6 to 10,
    wherein the second resonance mode is a lowest order mode of resonance modes in which the mirror part, the first actuator, and the second actuator tilt and oscillate in opposite phases to each other.

12. A method of driving the micromirror device according to any one of claims 1 to 6, the method comprising:
    exciting the first resonance mode, in which the mirror part tilts and oscillates around the first axis, and the second resonance mode, in which the mirror part and the first actuator tilt and oscillate around the second axis, by applying a driving signal to the piezoelectric element of each of the first actuator and the second actuator.

13. The method of driving the micromirror device according to claim 12,
    wherein the driving signal is applied to each of the plurality of piezoelectric parts of each piezoelectric element, the driving signal being obtained by superimposing a first driving signal and a second driving signal, wherein, in the first driving signal, a driving voltage waveform applied to a piezoelectric part located in a region where the principal stress component having the maximum absolute value is positive and a driving voltage waveform applied to a piezoelectric part located in a region where the principal stress component having the maximum absolute value is negative are in an opposite phase relationship with each other at a time when an oscillation amplitude in a case of driving in the first resonance mode is maximized, and in the second driving signal, a driving voltage waveform applied to the piezoelectric part located in a region where the principal stress component having the maximum absolute value is positive and a driving voltage waveform applied to the piezoelectric part located in a region where the principal stress component having the maximum absolute value is negative are in an opposite phase relationship with each other at a time when an oscillation amplitude in a case of driving in the second resonance mode is maximized.

14. The method of driving the micromirror device according to claim 12 or 13,
   wherein as the driving signal, a driving signal Vxy represented by Expression (1) is applied to each of the plurality of piezoelectric parts in accordance with each placement thereof:

$$\text{Vxy} = \alpha_1 V_1 \sin(2\pi f_1 t + \beta_1 \pi) + \alpha_2 V_2 \sin(2\pi f_2 t + \beta_2 \pi) \quad (1),$$

   wherein xy is a reference sign that specifies each of the plurality of piezoelectric parts, and $V_i$, $V_2$, $\alpha_1$, $\alpha_2$, $\beta_1$, $\beta_2$, $f_1$, $f_2$, and t are values which are set for each piezoelectric part,
   $V_1$ is a basic voltage amplitude value of the first driving signal,
   $V_2$ is a basic voltage amplitude value of the second driving signal,
   $\alpha_1$ is a voltage amplitude correction coefficient for the first driving signal,
   $\alpha_2$ is a voltage amplitude correction coefficient for the second driving signal,
   $\beta_1$ is a phase correction coefficient for the first driving signal,
   $\beta_2$ is a phase correction coefficient for the second driving signal,
   $f_i$ is a frequency of the first driving signal,
   $f_2$ is a frequency of the second driving signal, and
   t is a time.

15. The method of driving the micromirror device according to claim 14,
   wherein, in the driving signal Vxy, a value of the correction coefficient $\alpha_1$ is larger, as the piezoelectric part is located in the region where the absolute value of the principal stress component having the maximum absolute value in a case of driving in the first resonance mode is larger, and a value of the correction coefficient $\alpha_2$ is larger, as the piezoelectric part is located in the region where the absolute value of the principal stress component having the maximum absolute value in a case of driving in the second resonance mode is larger.

16. The method of driving the micromirror device according to any one of claims 12 to 15,
   wherein, as the first resonance mode, a lowest order mode of the resonance modes, in which the mirror part and the first actuator tilt and oscillate in opposite phases to each other, is excited.

17. The method of driving the micromirror device according to any one of claims 12 to 16,
   wherein, as the second resonance mode, a lowest order mode of the resonance modes, in which the first actuator, the mirror part, and the second actuator tilt and oscillate in opposite phases to each other, is excited.

# FIG. 1

# FIG. 2

# FIG. 3

# FIG. 4

FIG. 5

# FIG. 6

## FIG. 7

## FIG. 8

## FIG. 9

## FIG. 10

# FIG. 11

# FIG. 12

# FIG. 13

## FIG. 14

## FIG. 15

## FIG. 16

## FIG. 17

# FIG. 18

# FIG. 19

# FIG. 20

# FIG. 21

# FIG. 22

## FIG. 23

## FIG. 24

# FIG. 25

# FIG. 26

# FIG. 27

FIG. 28

## INTERNATIONAL SEARCH REPORT

| International application No. |
|---|
| PCT/JP2020/006638 |

| A CLASSIFICATION OF SUBJECT MATTER |
|---|
| B81B 3/00(2006.01)i; H01L 41/09(2006.01)i; H01L 41/187(2006.01)i; G02B 26/08(2006.01)i; G02B 26/10(2006.01)i FI: G02B26/10 104Z; G02B26/10 C; G02B26/08 E; B81B3/00; H01L41/09; H01L41/187 |
| According to International Patent Classification (IPC) or to both national classification and IPC |

| B. FIELDS SEARCHED |
|---|
| Minimum documentation searched (classification system followed by classification symbols) B81B3/00; H01L41/09; H01L41/187; G02B26/08; G02B26/10; H02N2/00 |

| Documentation searched other than minimum documentation to the extent that such documents are included in the fields searched |  |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

| Electronic data base consulted during the international search (name of data base and, where practicable, search terms used) |
|---|
|  |

### C. DOCUMENTS CONSIDERED TO BE RELEVANT

| Category* | Citation of document, with indication, where appropriate, of the relevant passages | Relevant to claim No. |
|---|---|---|
| X | JP 2008-020701 A (STANLEY ELECTRIC CO., LTD.) 31.01.2008 (2008-01-31) paragraphs [0015]-[0074] , fig. 1-6 | 1-2, 5-6, 12 |
| Y | paragraphs [0015]-[0074] , fig. 1-6 | 3-8, 10-14, 16-17 |
| A | paragraphs [0015]-[0074] , fig. 1-6 | 3, 15 |
| Y | JP 2015-022065 A (FUJIFILM CORPORATION) 02.02.2015 (2015-02-02) paragraphs [0041]-[0245] , fig. 1-28 | 3-8, 10-14, 16-17 |
| Y | WO 2010/021216 A1 (KONICA MINOLTA OPTO, INC.) 25.02.2010 (2010-02-25) paragraphs [0034]-[0168], fig. 9-13 | 7-8, 10-11, 13-14, 16-17 |
| Y | JP 2017-010005 A (RICOH CO., LTD.) 12.01.2017 (2017-01-12) claims 1, 11 | 10-11, 16-17 |

| ☒ Further documents are listed in the continuation of Box C. | ☒ See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 10 April 2020 (10.04.2020) | 28 April 2020 (28.04.2020) |

| Name and mailing address of the ISA/ Japan Patent Office 3-4-3, Kasumigaseki, Chiyoda-ku, Tokyo 100-8915, Japan | Authorized officer

Telephone No. |
|---|---|

Form PCT/ISA/210 (second sheet) (January 2015)

**INTERNATIONAL SEARCH REPORT**

International application No.

PCT/JP2020/006638

C (Continuation). DOCUMENTS CONSIDERED TO BE RELEVANT

| Category* | Citation of document, with indication, where appropriate, of the relevant passages | Relevant to claim No. |
|---|---|---|
| A | WO 2018/179589 A1 (MITSUBISHI ELECTRIC CORP.) 04.10.2018 (2018-10-04) entire text, all drawings | 1-17 |
| A | JP 2009-192781 A (PANASONIC CORP.) 27.08.2009 (2009-08-27) entire text, all drawings | 1-17 |
| A | US 2016/0211439 A1 (THE RECENTS OF THE UNIVERSITY OF MICHICAN) 21.07.2016 (2016-07-21) entire text, all drawings | 1-17 |

Form PCT/ISA/210 (continuation of second sheet) (January 2015)

International application no.

PCT/JP2020/006638

| Patent Documents referred in the Report | Publication Date | Patent Family | Publication Date |
|---|---|---|---|
| JP 2008-020701 A | 31 Jan. 2008 | (Family: none) | |
| JP 2015-022065 A | 02 Feb. 2015 | US 2015/0309307 A1 paragraphs [0074]-[0290], fig. 1-28 EP 2827182 A1 CN 104297919 A | |
| WO 2010/021216 A1 | 25 Feb. 2010 | US 2011/0141538 A1 paragraphs [0064]-[0198], fig. 9-13 EP 2317365 A1 | |
| JP 2017-010005 A | 12 Jan. 2017 | EP 3109685 A1 claims 1, 11 | |
| WO 2018/179589 A1 | 04 Oct. 2018 | CN 110462485 A entire text, all drawings | |
| JP 2009-192781 A | 27 Aug. 2009 | (Family: none) | |
| US 2016/0211439 A1 | 21 Jul. 2016 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6092713 B
- WO 2016052547 A
- JP 5151065 B
- JP 4984117 B
- JP 2018041085 A
- JP 2019063659 A